(19) Europäisches Patentamt
European Patent Office
Office européen des brevets

(11) EP 4 203 648 A1

(12) **EUROPEAN PATENT APPLICATION**

(43) Date of publication:
**28.06.2023 Bulletin 2023/26**

(21) Application number: **22216871.8**

(22) Date of filing: **28.12.2022**

(51) International Patent Classification (IPC):
***H10K 50/16*** *(2023.01)* ***H10K 50/165*** *(2023.01)*

(52) Cooperative Patent Classification (CPC):
**H10K 50/165;** H10K 50/115; H10K 85/731;
H10K 2102/331

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **27.12.2021 KR 20210188672**

(71) Applicant: **Samsung Electronics Co., Ltd.**
**Gyeonggi-do 16677 (KR)**

(72) Inventors:
- **HAN, Moon Gyu**
  **16678 Suwon-si (KR)**
- **LEE, Heejae**
  **16678 Suwon-si (KR)**
- **JANG, Eun Joo**
  **16678 Suwon-si (KR)**

(74) Representative: **Elkington and Fife LLP**
**Prospect House**
**8 Pembroke Road**
**Sevenoaks, Kent TN13 1XR (GB)**

# (54) ELECTROLUMINESCENT DEVICE, PRODUCTION METHOD THEREOF, AND DISPLAY DEVICE INCLUDING THE SAME

(57) An electroluminescent device including an anode, a cathode, and a light emitting layer disposed between the anode and the cathode, the light emitting layer includes a plurality of semiconductor nanoparticles; and an electron transport layer disposed between the light emitting layer and the cathode. The electron transport layer includes zinc oxide nanoparticles and an organic liquid crystal compound. A production method to the electroluminescent device or a display device is also disclosed.

FIG. 1

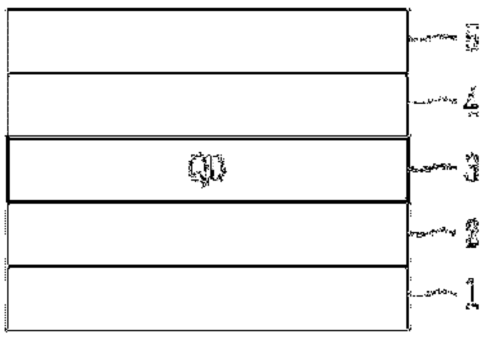


EP 4 203 648 A1

**Description**

FIELD OF THE INVENTION

The present disclosure relates to an electroluminescent device, a production method thereof, and a display device including the same.

BACKGROUND OF THE INVENTION

Semiconductor particles of nanoscale size (e.g., semiconductor nanocrystal particles) may exhibit luminescence. For example, quantum dots including semiconductor nanocrystals may exhibit a quantum confinement effect. Light emission from semiconductor nanoparticles may be generated while, e.g., when, electrons in an excited state transition from a conduction band to a valence band by, for example, light excitation or voltage application. Semiconductor nanoparticles may be controlled to emit light in a desired wavelength region by controlling sizes thereof, compositions thereof, or a combination thereof. The nanoparticles may be used in a light emitting device (e.g., an electroluminescent device) and display devices including the same.

SUMMARY OF THE INVENTION

An embodiment relates to a light emitting device including a nanostructure (e.g., quantum dots) that emits light by applying a voltage.

An embodiment relates to a display device (e.g., a quantum dot (QD)-light emitting diode (LED) display) including semiconductor nanoparticles (e.g., quantum dots) as a light emitting material present in one or more pixels of a display device.

In an embodiment, the electroluminescent device includes

> an anode; a cathode (for example, each with a surface facing the other); and a light emitting layer comprising a plurality of semiconductor nanoparticles, the light emitting layer disposed between the anode and the cathode; and an electron transport layer disposed between the light emitting layer and the cathode, wherein the electron transport layer includes zinc oxide nanoparticles and an organic liquid crystal compound.

The electroluminescent device may further include a hole auxiliary layer between the light emitting layer and the anode. The hole auxiliary layer may include a hole transport layer (e.g., including an organic compound), a hole injection layer, or a combination thereof.

The plurality of semiconductor nanoparticles may include a first semiconductor nanocrystal including zinc, selenium, and tellurium, and a second semiconductor nanocrystal including a zinc chalcogenide and being different from the first semiconductor nanocrystal.

The plurality of semiconductor nanoparticles may include a first semiconductor nanocrystal including indium, phosphorus, and optionally zinc and a second semiconductor nanocrystal including a zinc chalcogenide, the second semiconductor nanocrystal being different from the first semiconductor nanocrystal.

An average size of the plurality of the semiconductor nanoparticles may be greater than or equal to about 4 nanometers (nm), greater than or equal to about 5 nm, greater than or equal to about 7 nm, greater than or equal to about 8 nm, greater than or equal to about 9 nm, or greater than or equal to about 10 nm. An average size of the plurality of semiconductor nanoparticles may be less than or equal to about 30 nm, less than or equal to about 20 nm, less than or equal to about 15 nm, less than or equal to about 12 nm, or less than or equal to about 10 nm.

The plurality of semiconductor nanoparticles may include a core including the first semiconductor nanocrystal and a shell disposed on the core and including the second semiconductor nanocrystal.

In an embodiment, the zinc oxide nanoparticles may have a size or an average size (hereinafter, "a size") of greater than or equal to about 0.5 nanometers (nm).

The zinc oxide nanoparticles may have a size of less than or equal to about 50 nm.

The zinc oxide nanoparticles may have a size of less than or equal to about 20 nm.

The zinc oxide nanoparticles may have a size of greater than or equal to about 2 nm and less than or equal to about 10 nm, greater than or equal to about 2.5 nm and less than or equal to about 7 nm, greater than or equal to about 3 nm and less than or equal to about 5 nm, or a combination thereof.

The zinc oxide nanoparticle may further include a Group IIA metal, zirconium (Zr), tungsten (W), lithium (Li), titanium (Ti), yttrium (Y), aluminum (Al), gallium (Ga), indium (In), tin (Sn), cobalt (Co), vanadium (V), or a combination thereof.

The Group IIA metal (i.e., an alkaline-earth metal) may include magnesium, calcium, beryllium, strontium,

barium, or a combination thereof.

The zinc oxide nanoparticle may further include an alkali metal.

The alkali metal may include cesium, potassium, rubidium, or a combination thereof.

The organic liquid crystal compound may include a thermotropic liquid crystal compound having a (e.g., C3 to C60) cyclic moiety such as an aromatic moiety, an alicyclic moiety, or a combination thereof.

In an embodiment, the cyclic moiety may include or may not include a heteroaromatic moiety, a hetero alicyclic moiety, or a combination thereof.

In the electron transport layer, an amount of the organic liquid crystal compound may be greater than or equal to about 0.01 weight percent (wt%), greater than or equal to about 0.1 wt%, or greater than or equal to about 1 wt%, based on a total weight of the zinc oxide nanoparticle and the organic liquid crystal compound. In the electron transport layer, an amount of the organic liquid crystal compound may be less than or equal to about 30 wt%, less than or equal to about 20 wt%, less than or equal to about 10 wt%, or less than or equal to about 5 wt%, based on a total weight of the zinc oxide nanoparticle and the organic liquid crystal compound.

The organic liquid crystal compound may include a compound represented by Chemical Formula 1:

Chemical Formula 1 $R^1$-Ar- L-$R^2$

wherein

$R^1$ is a substituted or unsubstituted C1 to C50 aliphatic hydrocarbon group, RO-, or RC(O)-, wherein, R is a substituted or unsubstituted C1 to C50 alkyl group, a substituted or unsubstituted C2 to C50 alkenyl group, or a substituted or unsubstituted C2 to C50 alkynyl group,

Ar is a substituted or unsubstituted C3 to C50 aromatic moiety, a substituted or unsubstituted C4 to C50 alicyclic moiety, or any combination thereof (e.g., a moiety formed by any combination of a C3 to C50 aromatic moiety and a C4 to C50 alicyclic moiety),

L is a direct bond, a substituted or unsubstituted C1 to C20 (e.g., C2 to C10) aliphatic hydrocarbon group, C(O), O, C(O)O, NH, NHC(O), or any combination thereof (e.g., a moiety formed by any combination of the foregoing moieties),

$R^2$ is hydrogen, a cyano group, a halogen, $-CX_3$, $-CRX_2$, $-CR_2X$ (wherein R is each independently hydrogen or a C1 to C10 alkyl group, X is each independently F, Cl, Br, I, or a combination thereof), or a carboxylic acid group.

In Chemical Formula 1, $R^1$ may be $C_nH_{2n+1}$, $C_nH_{2n-1}$, $C_nH_{2n+1}O$, $C_nH_{2n-1}O$, $C_nH_{2n+1}C(O)$, $C_nH_{2n-1}C(O)$, or a combination thereof, wherein n is an integer from 1 (or 2, 3, or 4) to 30.

In chemical formula 1, Ar may be a substituted or unsubstituted biphenyl moiety (e.g., a substituted or unsubstituted biphenylene group), a substituted or unsubstituted phenyl moiety (e.g., a substituted or unsubstituted phenylene group or benzene ring moiety), a substituted or unsubstituted terphenyl moiety (e.g., a substituted or unsubstituted terphenylene group), a substituted or unsubstituted pyrimidine moiety, a substituted or unsubstituted pyridine moiety, a substituted or unsubstituted dioxane moiety, a substituted or unsubstituted furan moiety, a substituted or unsubstituted thiophen moiety, a substituted or unsubstituted pyridazine moiety, or any combination thereof (e.g., a moiety formed by any combination of the foregoing moieties).

In Chemical Formula 1, L may be a direct bond, a substituted or unsubstituted C1 to C10 alkylene group, a substituted or unsubstituted C2 to C10 alkenylene group, CO, O, C(O)O, NH, NHC(O), or any combination thereof (e.g., a moiety formed by any combination of the foregoing moieties).

In Chemical Formula 1, $R^2$ may be a cyano group or a carboxylic acid group.

The organic liquid crystal compound may include a biphenyl carbonitrile compound, a phenyl cyclohexane compound, a biphenyl cyclohexane compound, a fluorinated cyclohexane biphenyl compound, a fluorinated terphenyl compound, a benzoic acid compound having a substituted or unsubstituted C1 to C30 aliphatic hydrocarbon group (for example, an alkyl benzoic acid compound), an acetyl benzoic acid compound, or a combination thereof.

The organic liquid crystal compound may have a molecular weight of greater than or equal to about 10 grams per mole (g/mol).

The organic liquid crystal compound may have a molecular weight of less than or equal to about 1500 g/mol, or less than or equal to about 800 g/mol.

The organic liquid crystal compound may be non-emissive.

The organic liquid crystal compound may not include an anthracene moiety, a dibenzothiophene moiety, or a combination thereof.

The organic liquid crystal compound may include or may not include a naphthalene moiety.

The electron transport layer may have a first surface facing the light emitting layer and a second surface opposite the first surface, and an amount of the organic liquid crystal compound in a portion of the electron transport layer proximate to the first surface may be greater than an amount of the organic liquid crystal compound in a portion proximate to the

second surface of the electron transport layer.

The electron transport layer may be disposed on (or disposed directly on or in contact with) the light emitting layer.

A thickness of the electron transport layer may be greater than or equal to about 5 nanometers (nm) and less than about 60 nm.

The electroluminescent device may have a maximum external quantum efficiency of greater than or equal to about 6%, greater than or equal to about 10%, greater than or equal to about 11 %, greater than or equal to about 12%, greater than or equal to about 13%, or greater than or equal to about 15%.

In an embodiment, as measured by driving the device at a predetermined luminance (for example, at about 650 nit) the electroluminescent device may have a T90 of greater than or equal to about 15 hours, greater than or equal to about 16 hours, greater than or equal to about 17 hours, greater than or equal to about 20 hours, greater than or equal to about 23 hours, greater than or equal to about 25 hours, or greater than or equal to about 30 hours.

In an embodiment, as measured by driving the device at a predetermined luminance (for example, about 650 nit) the electroluminescent device may have a T50 of greater than or equal to about 110 hours, greater than or equal to about 115 hours, greater than or equal to about 120 hours, greater than or equal to about 125 hours, greater than or equal to about 130 hours, greater than or equal to about 140 hours, or greater than or equal to about 145 hours.

The electroluminescent device may have a maximum luminance of greater than or equal to about 60,000 candelas per square meter ($cd/m^2$) or greater than or equal to about 72,000 $cd/m^2$.

In an embodiment, a layered structure includes a first electron injecting conductor and a first electron transporting layer disposed on a surface of the first electron injecting conductor, wherein the first electron transporting layer may include zinc oxide nanoparticles and an organic liquid crystal compound, wherein the organic liquid crystal compound includes a cyclic group (e.g., an aromatic group); a substituted or unsubstituted C1 to C30 aliphatic hydrocarbon group; and a nitrile group or a carboxylic acid group. In an embodiment, the zinc oxide nanoparticles have a size (or an average size) of greater than or equal to about 0.5 nm and less than or equal to about 50 nm.

In the first electron transporting layer, an amount of the organic liquid crystal compound may be greater than or equal to about 0.01 wt% and less than or equal to about 30 wt%, based on a total weight of the zinc oxide nanoparticle and the organic liquid crystal compound.

The organic liquid crystal compound may include a biphenyl carbonitrile compound, a phenyl cyclohexane compound, a biphenyl cyclohexane compound, a fluorinated cyclohexane biphenyl compound (for example, having a fluorinated biphenyl moiety), a fluorinated terphenyl compound, a benzoic acid compound having a substituted or unsubstituted C1 to C30 aliphatic hydrocarbon group, an acetyl benzoic acid compound, or a combination thereof.

The layered structure may further include a light emitting layer disposed on the first electron transport layer, a second electron transport layer disposed on the light emitting layer, and a second electron injecting conductor disposed on the second electron transport layer.

The layered structure may exhibit a current density of greater than or equal to about 100 milliamperes per square meter ($mA/m^2$) at a voltage of 8 volts.

The layered structure may exhibit a voltage increase of less than or equal to about 1.5 volts, when a current of about 0.2 milliamperes is applied to the structure.

In an embodiment, a display device includes the electroluminescent device.

The display device may include a portable terminal device, a monitor, a notebook computer, a television, an electric sign board, a camera, or an electronic component.

## BRIEF DESCRIPTION OF THE DRAWINGS

The above and other advantages and features of this disclosure will become more apparent by describing in further detail exemplary embodiments thereof with reference to the accompanying drawings, in which:

FIG. 1 is a schematic cross-sectional view of an electroluminescent device according to an embodiment;
FIG. 2 is a schematic cross-sectional view of an electroluminescent device according to an embodiment; and
FIG. 3 is a schematic cross-sectional view of an electroluminescent device according to an embodiment.
FIG. 4 is a view showing a result of a EOD sweep test for a device of Comparative Example 2.
FIG. 5 is a view showing a result of an EOD sweep test for a device of Example 6.
FIG. 6 is a view showing a result of an ETL current stability test conducted in Experimental Example 2.

## DETAILED DESCRIPTION OF THE EMBODIMENTS

Hereinafter, with reference to the accompanying drawings, various embodiments of the present disclosure will be described in detail so that those of ordinary skill in the art can easily carry out the present disclosure. The present disclosure may be embodied in many different forms and is not limited to the embodiments described herein.

In order to clearly explain the present disclosure, parts irrelevant to the description are omitted, and the same reference numerals are assigned to the same or similar elements throughout the specification.

The size and thickness of each constituent element as shown in the drawings are indicated for better understanding and ease of description, and this disclosure is not necessarily limited to sizes or thicknesses as shown. In the drawings, the thickness of layers, films, panels, regions, etc., are exaggerated for clarity. And in the drawings, for convenience of description, the thickness of some layers and regions are exaggerated. The term "cross-sectional view" means a view in which a cross-section of the target part that is cut in a vertical direction is viewed from the side.

In addition, it will be understood that when an element such as a layer, film, region, or substrate is referred to as being "on" another element, it can be directly on the other element or intervening elements may also be present. In contrast, when an element is referred to as being "directly on" another element, there are no intervening elements present. Also, to be disposed "on" the reference portion means to be disposed above or below the reference portion and does not necessarily mean "above" in an opposite direction of gravity.

Further, the singular includes the plural unless mentioned otherwise. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items.

It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms "first," "second," "third," etc., may be used herein to describe various elements, components, regions, layers, and/or sections, these elements, components, regions, layers and/or sections should not be limited by these terms. These terms are only used to distinguish one element, component, region, layer, or section from another element, component, region, layer, or section. Thus, "a first element," "component," "region," "layer," or "section" discussed below could be termed a second element, component, region, layer, or section without departing from the teachings herein.

Unless otherwise defined, all terms (including technical and scientific terms) used herein have the same meaning as commonly understood by one of ordinary skill in the art to which this disclosure belongs. It will be further understood that terms, such as those defined in commonly used, e.g., non-technical, dictionaries, should be interpreted as having a meaning that is consistent with their meaning in the context of the relevant art and the present disclosure, and will not be interpreted in an idealized or overly formal sense unless expressly so defined herein.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Hereinafter, values of a work function, a conduction band, or a lowest unoccupied molecular orbital (LUMO) (or valence band or highest occupied molecular orbital (HOMO)) energy level is expressed as an absolute value from a vacuum level. In addition, when the work function or the energy level is referred to be "deep," "high" or "large," the work function or the energy level has a large absolute value based on "0 electronvolts (eV)" of the vacuum level, while when the work function or the energy level is referred to be "shallow," "low," or "small," the work function or energy level has a small absolute value based on "0 eV" of the vacuum level.

As used herein, the average (value) may be mean or median. In an embodiment, the average (value) may be a mean average.

As used herein, a number of carbon atoms in a group or a molecule may be referred to as a subscript (e.g., $C_{6-50}$) or as C6 to C50.

As used herein, when a definition is not otherwise provided, "substituted" refers to replacement of a, e.g., at least one, hydrogen of a compound or the corresponding moiety by a C1 to C30 alkyl group, a C2 to C30 alkenyl group, a C2 to C30 alkynyl group, a C6 to C30 aryl group, a C4 (or C7) to C30 alkylaryl group, a C1 to C30 alkoxy group, a C1 to C30 heteroalkyl group, a C3 to C30 heteroalkylaryl group, a C3 to C30 cycloalkyl group, a C3 to C15 cycloalkenyl group, a C6 to C30 cycloalkynyl group, a C2 to C30 heterocycloalkyl group, a halogen (-F, -Cl, -Br, or -I), a hydroxy group (-OH), a nitro group ($-NO_2$), a cyano group (-CN), an amino group (-NRR' wherein R and R' are each independently hydrogen or a C1 to C6 alkyl group), an azido group ($-N_3$), an amidino group ($-C(=NH)NH_2$), a hydrazino group ($-NHNH_2$), a hydrazono group ($=N(NH_2)$), an aldehyde group (-C(=O)H), a carbamoyl group ($-C(O)NH_2$), a thiol group (-SH), an

ester group (-C(=O)OR, wherein R is a C1 to C6 alkyl group or a C6 to C12 aryl group), a carboxyl group (-COOH) or a salt thereof (-C(=O)OM', wherein M' is an organic or inorganic cation), a sulfonic acid group (-SOsH) or a salt thereof (-SOsM', wherein M' is an organic or inorganic cation), a phosphoric acid group ($-PO_3H_2$) or a salt thereof ($-PO_3M'H$ or $-PO_3M'_2$, wherein M' is an organic or inorganic cation), or a combination thereof.

In an embodiment, a biphenyl carbonitrile compound refers to a compound having a biphenyl carbonitrile moiety and optionally further having (i.e., with or without) a substituent group.

In an embodiment, a phenyl cyclohexane compound refers to a compound having a phenylcyclohexane moiety and optionally further having (i.e., with or without) a substituent group.

In an embodiment, a biphenyl cyclohexane compound refers to a compound having a biphenyl cyclohexane moiety and optionally further having (i.e., with or without) a substituent group.

In an embodiment, a terphenyl compound refers to a compound having a terphenyl moiety and optionally further having (i.e., with or without) a substituent group.

As used herein, when a definition is not otherwise provided, a substituent group may be a C1 to C30 alkyl group, a C2 to C30 alkenyl group, a C2 to C30 alkynyl group, a C6 to C30 aryl group, a C4 or C7 to C30 alkylaryl group, a C1 to C30 alkoxy group, a C1 to C30 heteroalkyl group, a C3 to C30 heteroalkylaryl group, a C3 to C30 cycloalkyl group, a C3 to C15 cycloalkenyl group, a C6 to C30 cycloalkynyl group, a C2 to C30 heterocycloalkyl group, a halogen (-F, -Cl, -Br, or -I), a hydroxy group (-OH), a nitro group ($-NO_2$), a cyano group (-CN), an amino group (-NRR' wherein R and R' are each independently hydrogen or a C1 to C6 alkyl group), an azido group ($-N_3$), an amidino group ($-C(=NH)NH_2$), a hydrazino group ($-NHNH_2$), a hydrazono group ($=N(NH_2)$), an aldehyde group (-C(=O)H), a carbamoyl group ($-C(O)NH_2$), a thiol group (-SH), an ester group (-C(=O)OR, wherein R is a C1 to C6 alkyl group or a C6 to C12 aryl group), a carboxyl group (-COOH) or a salt thereof (-C(=O)OM', wherein M' is an organic or inorganic cation), a sulfonic acid group (-SOsH) or a salt thereof (-SOsM', wherein M' is an organic or inorganic cation), a phosphoric acid group ($-PO_3H_2$) or a salt thereof ($-PO_3M'H$ or $-PO_3M'_2$, wherein M' is an organic or inorganic cation), or a combination thereof.

As used herein, the term "a combination thereof" may refer to a mixture, an alloy, or a moiety that can be formed by linking at least two selected from the recited chemical moieties.

As used herein, when a definition is not otherwise provided, a "hydrocarbon" or "hydrocarbon group" refers to a compound or a group containing carbon and hydrogen (e.g., an aliphatic group such as an alkyl, alkenyl, or alkynyl group, an aromatic group such as an aryl group, or an alicyclic group). The hydrocarbon group may be a monovalent group or a group having a valence of greater than one formed by removal of one or more hydrogen atoms from alkane, alkene, alkyne, or arene. In the hydrocarbon group of an embodiment, a, e.g., at least one, methylene may be replaced by an oxide moiety, a carbonyl moiety, an ester moiety, -NH-, or a combination thereof. Unless otherwise stated to the contrary, the hydrocarbon (alkyl, alkenyl, alkynyl, aryl,or alicyclic) group may have 1 to 60, 2 to 32, 3 to 24, or 4 to 12 carbon atoms. In an embodiment, "aliphatic hydrocarbon" may be a saturated or unsaturated, linear or branched C1 to C30 hydrocarbon group including (or consisting of) carbon and hydrogen. In an embodiment, "aromatic" or "aromatic group" may include a C6 to C30 aryl group or a C3 to C30 heteroaryl group.

The term "alicyclic group" refers to not only a saturated or unsaturated C3 to C30 cyclic group consisting of carbon and hydrogen but also a saturated or unsaturated C3 to C30 heterocyclic group that further includes a hetero atom in addition to carbon and hydrogen.

As used herein, when a definition is not otherwise provided, "alkyl" refers to a linear or branched saturated monovalent hydrocarbon group (methyl, ethyl hexyl, etc.). Unless specified otherwise, an alkyl group has from 1 to 50 carbon atoms, or 1 to 18 carbon atoms, or 1 to 12 carbon atoms.

As used herein, when a definition is not otherwise provided, "alkenyl" refers to a linear or branched monovalent hydrocarbon group having one or more carboncarbon double bond. In an embodiment, an alkenyl group may have from 2 to 50 carbon atoms, or 2 to 18 carbon atoms, or 2 to 12 carbon atoms.

As used herein, when a definition is not otherwise provided, "alkynyl" refers to a linear or branched monovalent hydrocarbon group having one or more carboncarbon triple bond. In an embodiment, an alkynyl group may have from 2 to 50 carbon atoms, or 2 to 18 carbon atoms, or 2 to 12 carbon atoms.

As used herein, when a definition is not otherwise provided, "aryl" or "heteroaryl" refers to a group formed by removal of a, e.g., at least one, hydrogen from an aromatic group (e.g., a phenyl, naphthyl, pyridyl group). In an embodiment, an aryl group may have from 6 to 50 carbon atoms, or 6 to 18 carbon atoms, or 6 to 12 carbon atoms. In an embodiment, a heteroaryl group may have from 5 to 50 carbon atoms, or 5 to 18 carbon atoms, or 5 to 12 carbon atoms.

As used herein, "cyclic group" refers to an aromatic, alicyclic, or heterocyclic group with one or more rings, which may include two or more condensed rings.

As used herein, when a definition is not otherwise provided, "hetero" refers to a group including 1 to 3 heteroatoms of N, O, S, Si, P, or a combination thereof.

In an embodiment, "alkylene group" may be a straight or branched saturated aliphatic hydrocarbon group having at least two valences and optionally substituted with a, e.g., at least one, substituent.

In an embodiment, "arylene group" or "heteroarylene" may be a group having at least two valences obtained by removal of at least two hydrogens in an, e.g., at least one, aromatic ring, and optionally substituted with a, e.g., at least one, substituent.

As used herein, when a definition is not otherwise provided, "alkoxy" means an alkyl group linked via an oxygen (i.e., alkyl-O-), such as a methoxy, ethoxy, or sec-butyloxy group.

As used herein, when a definition is not otherwise provided, "amine group" may be represented by -NRR, wherein each R is independently hydrogen, a C1 to C12 alkyl group, a C7 to C20 alkylaryl group, a C7 to C20 arylalkyl group, or a C6 to C18 aryl group.

As used herein, when a definition is not otherwise provided, "fluorinated" means that one or more hydrogens of the stated hydrocarbon is substituted with a fluorine.

As used herein, a description of not containing harmful heavy metals such as cadmium may refer to a concentration of cadmium (or a corresponding heavy metal) of less than or equal to about 100 parts per million by weight (ppmw), less than or equal to about 50 ppmw, less than or equal to about 10 ppmw, or about zero ppmw. In an embodiment, substantially no cadmium (or other heavy metal) is present, or, if present, in an amount or impurity level below the detection limit of a given detection means.

In an embodiment, numerical ranges stated herein are inclusive of the endpoint of each range. As used herein, the upper and lower endpoints set forth for various numerical values may be independently combined to provide a range.

As used herein, "substantially" or "about" means not only the stated value, but also the mean within an acceptable range of deviations, considering the errors associated with the corresponding measurement and the measurement of the measured value. For example, "substantially" can mean within ± 10%, 5%, 3%, or 1 % or within standard deviation of the stated value.

Herein, a nanostructure or a nanoparticle is a structure having a, e.g., at least one, region or characteristic dimension with a dimension of less than or equal to about 500 nm. In an embodiment, the dimension of the nanoparticle may be less than about 300 nm, less than about 250 nm, less than about 150 nm, less than about 100 nm, less than about 50 nm, or less than about 30 nm. The structures may have any suitable shape.

Unless otherwise specified herein, the nanoparticles or semiconductor nanoparticles may have any suitable shape, such as nanowires, nanorods, nanotubes, multi-pod type shapes having two or more pods, nanodots (or quantum dots), etc., and are not particularly limited. The nanoparticles may be, for example, substantially crystalline, substantially monocrystalline, polycrystalline, amorphous, or a combination thereof.

For example, semiconductor nanoparticles such as quantum dots may exhibit quantum confinement or exciton confinement. In the present specification, the term "nanoparticles or quantum dots" are not limited in shapes thereof unless specifically defined. Semiconductor nanoparticles, such as quantum dots, may have a size smaller than a diameter of Bohr excitation in the bulk crystal of the same material, and may exhibit a quantum confinement effect. Quantum dots may emit light corresponding to a bandgap energy thereof by controlling the size of the emission center of the nanocrystals.

Herein, T50 refers to a time for luminance of a given device to decrease to 50% of the initial luminance when the device is driven at predetermined luminance.

Herein, T90 refers to a time for luminance of a given device to decrease to 90% of the initial luminance when the device is driven at predetermined luminance.

Herein, external quantum efficiency (EQE) refers to a ratio of the number of photons emitted from a light emitting diode (LED) to the number of electrons passing through the device. EQE may be a criteria of how efficiently the light emitting diode converts the electrons into emitted photons. In an embodiment, EQE may be determined based on the following equation:

$$\text{EQE} = (\text{Injection efficiency}) \times (\text{Solid state quantum yield}) \times (\text{Extraction efficiency})$$

Injection efficiency = proportion of electrons passing through the device that are injected into the active region;
Solid state quantum yield = proportion of all electron-hole recombinations in the active region that are radiative and produce photons; and
Extraction efficiency = proportion of photons generated in the active region that escape from the device.

Herein, the maximum external quantum efficiency refers to the maximum value of the external quantum efficiency.

Herein, the maximum luminance refers to a maximum value of luminance that the device can achieve.

Herein, quantum efficiency is a term used interchangeably with quantum yield. Quantum efficiency (or quantum yield) may be measured either in solution or in the solid state (in a composite). In an embodiment, quantum efficiency

(or quantum yield) is the ratio of photons emitted to photons absorbed by the nanostructure or population thereof. In an embodiment, quantum efficiency may be measured by any suitable method. For example, for fluorescence quantum yield or efficiency, there may be two methods: an absolute method and a relative method.

In the absolute method, quantum efficiency is obtained by detecting the fluorescence of all samples through an integrating sphere. In the relative method, the quantum efficiency of the unknown sample is calculated by comparing the fluorescence intensity of a standard dye (standard sample) with the fluorescence intensity of the unknown sample. Coumarin 153, Coumarin 545, Rhodamine 101 inner salt, Anthracene and Rhodamine 6G may be used as standard dyes according to photoluminescence (PL) wavelengths thereof, but the present disclosure is not limited thereto.

Bandgap energies of semiconductor nanocrystal particles may be changed according to sizes, structures, and compositions of nanocrystals. Semiconductor nanocrystals may be used as light emitting materials in various fields of a display device, an energy device, or a bio light emitting device, for example.

A semiconductor nanocrystal particle-based light emitting device (hereinafter, also referred to as a QD-LED) that emits light by application of a voltage includes semiconductor nanocrystal particles as a light emitting material. A QD-LED adopts a different emission principle from that of an organic light emitting diode (OLED) emitting light by using an organic material as an emission center, may realize, e.g., exhibit, purer colors (for example, red, green, and/or blue) and improved color reproducibility, and accordingly, may be used as a next generation display device. A QD-LED may be produced with a reduced cost by including a solution process, may be based on an inorganic material, and may be expected to realize e.g., exhibit, increased stability, but technology development for improving device properties and life-span characteristics is still desired.

In addition, quantum dots being configured to exhibit electroluminescent properties at a practically applicable, e.g., desirable, level may contain harmful heavy metals such as cadmium (Cd), lead, mercury, or a combination thereof. Accordingly, it is desirable to provide a light emitting device or a display device having a light emitting layer substantially free of the harmful heavy metal.

An electroluminescent device according to an embodiment is a luminescent type light emitting device configured to emit a desired light by applying a voltage in the absence of a light (irradiation) source

According to an embodiment, an electroluminescent device or an electrically conductive layered structure capable of implementing improved electroluminescent properties and lifetime properties is provided. In an embodiment, the layered structure may prevent or suppress a resistance change that can be occur otherwise due to a charging phenomenon for example in an electroluminescent device.

In an embodiment, the electroluminescent device of FIG. 1 includes an anode 1 and a cathode 5 spaced apart (e.g., opposite to each other); a light emitting layer 3 disposed between the anode and the cathode and including a plurality of semiconductor nanoparticles; and an electron transport layer (4) between the light emitting layer 3 and the cathode 5. The electroluminescent device may further include a hole auxiliary layer 2 between the light emitting layer and the anode. The hole auxiliary layer may include a hole transport layer (including, for example, an organic compound), a hole injection layer, or a combination thereof.

In the electroluminescent device of FIGS. 2 and 3, the anode 10 or the cathode 50 may be disposed on a (transparent) substrate 100, respectively. The transparent substrate may be a light extraction surface. Referring to FIGS. 2 and 3, the light emitting layer 30 may be disposed between the anode 10 and the cathode 50. The cathode 50 may include an electron injection conductor. The anode 10 may include a hole injection conductor. The work functions of the electron/hole injection conductors included in the cathode and the anode may be appropriately adjusted and are not particularly limited. For example, the cathode may have a small work function and the anode may have a relatively large work function, or vice versa.

The electron/hole injection conductors may include a metal-based material (e.g., a metal, a metal compound, an alloy, or a combination thereof) (aluminum, magnesium, tungsten, nickel, cobalt, platinum, palladium, calcium, LiF, etc.), a metal oxide such as gallium indium oxide or indium tin oxide (ITO), or a conductive polymer (e.g., having a relatively high work function) such as polyethylene dioxythiophene, but are not limited thereto.

The anode, the cathode, or a combination thereof may be a light-transmitting electrode or a transparent electrode. In an embodiment, both the anode and the cathode may be a light-transmitting electrode. The electrode may be patterned. The anode, the cathode, or a combination thereof may be disposed on a (e.g., insulating) substrate 100. The substrate 100 may be optically transparent (e.g., may have a light transmittance of greater than or equal to about 50%, greater than or equal to about 60%, greater than or equal to about 70%, greater than or equal to about 80%, greater than or equal to about 85%, or greater than or equal to about 90% and for example, less than or equal to about 99%, or less than or equal to about 95%). The substrate may further include a region for a blue pixel, a region for a red pixel, a region for a green pixel, or a combination thereof. A thin film transistor may be disposed in each of the stated regions of the substrate, and one of a source electrode and a drain electrode of the thin film transistor may be electrically connected to the anode or the cathode.

The light-transmitting electrode may be disposed on a (e.g., insulating) transparent substrate. The substrate may be rigid or flexible substrate. Accordingly, the substrate may be plastic, glass, or a metal.

The light-transmitting electrode may be made of, for example, a transparent conductor such as indium tin oxide (ITO) or indium zinc oxide (IZO), gallium indium tin oxide, zinc indium tin oxide, titanium nitride, polyaniline, LiF/Mg:Ag, or the like, or a thin metal thin film of a single layer or a plurality of layers, but is not limited thereto. When one of the anode and the cathode is an opaque electrode, the opaque electrode may be made of an opaque conductor such as aluminum (Al), a lithiumaluminum (Li:Al) alloy, a magnesium-silver alloy (Mg;Ag), and lithium fluoridealuminum (LiF:Al).

The thickness of each electrode (e.g., the anode, the cathode, or each of the anode and the cathode) is not particularly limited and may be appropriately selected taking into consideration device efficiency. For example, the thickness of the electrode may be greater than or equal to about 5 nm, greater than or equal to about 10 nm, greater than or equal to about 20 nm, greater than or equal to about 30 nm, greater than or equal to about 40 nm, or greater than or equal to about 50 nm. For example, the thickness of the electrode may be less than or equal to about 100 micrometers (μm), less than or equal to about 90 μm, less than or equal to about 80 μm, less than or equal to about 70 μm, less than or equal to about 60 μm, less than or equal to about 50 μm, less than or equal to about 40 μm, less than or equal to about 30 μm, less than or equal to about 20 μm, less than or equal to about 10 μm, less than or equal to about 1 μm, less than or equal to about 900 nm, less than or equal to about 500 nm, or less than or equal to about 100 nm.

A light emitting layer 3 or 30 is disposed between the anode 1 and the cathode 5 of FIG. 1 (or e.g., the anode 10 and the cathode 50 of FIGS. 2 and 3). The light emitting layer includes semiconductor nanoparticles (e.g., blue light emitting nanoparticles, red light emitting nanoparticles, or green light emitting nanoparticles). The light emitting layer may include one or more (e.g., 2 or more or 3 or more and 10 or less) monolayers of a plurality of nanoparticles.

The light emitting layer may be patterned. In an embodiment, the patterned light emitting layer may include a blue light emitting layer (e.g., disposed within a blue pixel in a display device to be described herein), a red light emitting layer (e.g., disposed within a red pixel in a display device to be described herein), a green light emitting layer (e.g., disposed within a green pixel in a display device to be described herein), or a combination thereof. Each of the light emitting layers may be (e.g., optically) separated from an adjacent light emitting layer by a partition wall. In an embodiment, a partition wall such as a black matrix may be disposed between the different color emitting layers, e.g., red light emitting layer, the green light emitting layer, and the blue light emitting layer. In an embodiment, the red light emitting layer, the green light emitting layer, and the blue light emitting layer may each be optically isolated.

In an embodiment, the light emitting layer or the semiconductor nanoparticles may exhibit a zinc blende crystal structure, a perovskite crystal structure, or a combination thereof.

The light emitting layer or semiconductor nanoparticle may not contain cadmium. The light emitting layer or semiconductor nanoparticle may not contain mercury, lead, or a combination thereof.

In an embodiment, the semiconductor nanoparticles may have a core-shell structure. The semiconductor nanoparticles may include a core including a first semiconductor nanocrystal and a shell including a second semiconductor nanocrystal disposed on the core and having a composition different from that of the first semiconductor nanocrystal.

The semiconductor nanoparticle (e.g., the first semiconductor nanocrystal, the second semiconductor nanocrystal, or a combination thereof) may include a Group II-VI compound, a Group III-V compound, a Group IV-VI compound, a Group IV element or compound, a Group I-III-VI compound, a Group I-II-IV-VI compound, or a combination thereof. The light emitting layer (or semiconductor nanoparticle, first semiconductor nanocrystal, or second semiconductor nanocrystal) may not contain harmful heavy metals such as cadmium, lead, mercury, or a combination thereof.

The Group II-VI compound may be a binary compound such as ZnS, ZnSe, ZnTe, ZnO, HgS, HgSe, HgTe, MgSe, MgS, or a combination thereof; a ternary compound such as ZnSeS, ZnSeTe, ZnSTe, HgSeS, HgSeTe, HgSTe, HgZnS, HgZnSe, HgZnTe, MgZnSe, MgZnS, or a combination thereof; a quaternary compound such as HgZnTeS, HgZnSeS, HgZnSeTe, HgZnSTe, or a combination thereof; or a combination thereof. The Group II-VI compound may further include a Group III metal.

The Group III-V compound may be a binary compound such as GaN, GaP, GaAs, GaSb, AIN, AlP, AlAs, AlSb, InN, InP, InAs, InSb, or a combination thereof; a ternary compound such as GaNP, GaNAs, GaNSb, GaPAs, GaPSb, AlNP, AlNAs, AlNSb, AlPAs, AlPSb, InNP, InNAs, InNSb, InPAs, InPSb, or a combination thereof; a quaternary compound such as GaAlNP, GaAlNAs, GaAlNSb, GaAlPAs, GaAlPSb, GalnNP, GalnNAs, GalnNSb, GalnPAs, GalnPSb, InAlNP, InAlNAs, InAlNSb, InAlPAs, InAlPSb, or a combination thereof; or a combination thereof. The Group III-V compound may further include a Group II element. An example of a first semiconductor nanocrystal is InZnP.

The Group IV-VI compound may be a binary compound such as SnS, SnSe, SnTe, or a combination thereof; a ternary compound such as SnSeS, SnSeTe, SnSTe, or a combination thereof; a quaternary compound such as SnSSeTe; or a combination thereof.

Examples of the Group I-III-VI compound include $CuInSe_2$, $CuInS_2$, CuInGaSe, and CuInGaS, but are not limited thereto.

Examples of the group I-II-IV-VI compound include, but are not limited to, CuZnSnSe and CuZnSnS.

The Group IV element or compound is a single element such as Si, Ge, or a combination thereof; a binary compound such as SiC, SiGe, or a combination thereof; or a combination of a single element and a binary compound.

In an embodiment, the first semiconductor nanocrystal may include a metal including indium, zinc, or a combination thereof and a non-metal including phosphorus, selenium, tellurium, sulfur, or a combination thereof. In an embodiment, the second semiconductor nanocrystal may include a metal including indium, zinc, or a combination thereof, and a non-metal including phosphorus, selenium, tellurium, sulfur, or a combination thereof.

In an embodiment, the first semiconductor nanocrystal may include InP, InZnP, ZnSe, ZnSeS, ZnSeTe, or a combination thereof; the second semiconductor nanocrystal may include ZnSe, ZnSeS, ZnS, ZnTeSe, or a combination thereof; or a combination thereof. In an embodiment, the shell may include zinc, sulfur, and optionally further include selenium in the outermost layer.

In an embodiment, the semiconductor nanoparticles may emit blue or green light and have a core including ZnSeTe, ZnSe, or a combination thereof and a shell including zinc chalcogenide (e.g., ZnS, ZnSe, ZnSeS, or a combination thereof). An amount of sulfur in the shell may increase or decrease in the radial direction (i.e., in a direction from the core toward the surface).

In an embodiment, the semiconductor nanoparticles may emit red or green light, the core may include InP, InZnP, or a combination thereof, and the shell may include a Group II metal including zinc and a non-metal including sulfur, selenium, or a combination thereof.

In an embodiment, when the semiconductor nanoparticles have a core-shell structure, an alloyed layer may or may not be present at the interface between the core and the shell. The alloyed layer may be a homogeneous alloy or may be a gradient alloy. In the gradient alloy, a concentration of elements present in the shell may have a concentration gradient that changes in the radial direction (e.g., decreases or increases in a direction toward the center of the core).

In an embodiment, the shell may have a composition that varies in a radial direction. In an embodiment, the shell may be a multilayered shell including two or more layers. In the multilayered shell, adjacent layers may have different compositions than the other. In the multilayered shell, a, e.g., at least one layer may independently include a semiconductor nanocrystal having a single composition. In the multilayered shell, a, e.g., at least one layer may independently have an alloyed semiconductor nanocrystal. In the multilayered shell, a e.g., at least one layer, may have a concentration gradient that radially changes in terms of a composition of a semiconductor nanocrystal.

In the core-shell structured semiconductor nanoparticles, the bandgap energy of the shell material may be greater than that of the core material but is not limited thereto. The bandgap energy of the shell material may be smaller than that of the core material. In the case of the multilayered shell, the bandgap energy of the outermost layer material of the shell may be greater than those of the core and/or the inner layer material of the shell (i.e., layers that are closer to the core). In the case of the multilayered shell, a semiconductor nanocrystal of each layer is selected to have an appropriate bandgap, thereby effectively exhibiting a quantum confinement effect.

The semiconductor nanoparticles of an embodiment may include, for example, an organic ligand, an organic solvent, or a combination thereof, in a state in which they are bonded or coordinated to the surface.

In an embodiment, an absorption/emission wavelength of the semiconductor nanoparticle may be controlled, for example, by adjusting composition, size, or a combination of composition and size of the semiconductor nanoparticle. The semiconductor nanoparticles included in the light emitting layer 3 or 30 may be configured to emit light of a desired color. The semiconductor nanoparticles may include blue light emitting semiconductor nanoparticles, green light emitting semiconductor nanoparticles, and/or red light emitting semiconductor nanoparticles.

A maximum emission peak wavelength of the semiconductor nanoparticle may have a wavelength range of ultraviolet to infrared wavelengths. For example, the maximum luminescent peak wavelength of the semiconductor nanoparticle may be greater than or equal to about 300 nm, greater than or equal to about 500 nm, greater than or equal to about 510 nm, greater than or equal to about 520 nm, greater than or equal to about 530 nm, greater than or equal to about 540 nm, greater than or equal to about 550 nm, greater than or equal to about 560 nm, greater than or equal to about 570 nm, greater than or equal to about 580 nm, greater than or equal to about 590 nm, greater than or equal to about 600 nm, or greater than or equal to about 610 nm. The maximum light emitting wavelength of the semiconductor nanoparticle may be in the range of less than or equal to about 1000 nm, less than or equal to about 800 nm, for example, less than or equal to about 650 nm, less than or equal to about 640 nm, less than or equal to about 630 nm, less than or equal to about 620 nm, less than or equal to about 610 nm, less than or equal to about 600 nm, less than or equal to about 590 nm, less than or equal to about 580 nm, less than or equal to about 570 nm, less than or equal to about 560 nm, less than or equal to about 550 nm, or less than or equal to about 540 nm. The maximum light emitting wavelength of the semiconductor nanoparticle may be in the range of about 500 nm to about 650 nm.

The semiconductor nanoparticles or the light emitting layer may emit green light, and the maximum emission wavelength may be in the range of greater than or equal to about 500 nm (e.g., greater than or equal to about 510 nm) and less than or equal to about 560 nm (e.g., less than or equal to about 540 nm). The semiconductor nanoparticle or the light emitting layer may emit red light, and the maximum emission wavelength may be in the range of greater than or equal to about 600 nm (e.g., greater than or equal to about 610 nm) and less than or equal to about 650 nm (e.g., less than or equal to about 640 nm). The semiconductor nanoparticle or the light emitting layer may emit blue light, and the maximum emission wavelength may be greater than or equal to about 440 nm (e.g., greater than or equal to about 450 nm) and less than or equal to about 480 nm (e.g., less than or equal to about 465 nm).

The semiconductor nanoparticle or the light emitting layer may exhibit a luminescent (e.g. photoluminescent or electroluminescent) spectrum having a relatively narrow full width at half maximum. In an embodiment, the semiconductor nanoparticle or the light emitting layer may have a full width at half maximum of less than or equal to about 45 nm, for example less than or equal to about 44 nm, less than or equal to about 43 nm, less than or equal to about 42 nm, less than or equal to about 41 nm, less than or equal to about 40 nm, less than or equal to about 39 nm, less than or equal to about 38 nm, less than or equal to about 37 nm, less than or equal to about 36 nm, or less than or equal to about 35 nm, in a photoluminescence spectrum thereof. The full width at half maximum may be greater than or equal to about 1 nm, greater than or equal to about 5 nm, greater than or equal to about 10 nm, greater than or equal to about 15 nm, or greater than or equal to about 20 nm.

The semiconductor nanoparticle or the light emitting layer may have (e.g., be configured to implement) a quantum yield of greater than or equal to about 10%, for example, greater than or equal to about 20%, greater than or equal to about 30%, greater than or equal to about 40%, greater than or equal to about 50%, greater than or equal to about 60%, greater than or equal to about 70%, greater than or equal to about 80%, greater than or equal to about 90%, or about 100%.

The semiconductor nanoparticle may have a size (e.g., a particle diameter in the case of a substantially spherical particle or a particle diameter calculated from a two-dimensional area confirmed by electron microscopy analysis in the case of a non-spherical particle) of greater than or equal to about 1 nm and less than or equal to about 100 nm. In an embodiment, the semiconductor nanoparticle may have a size of about 1 nm to about 50 nm, for example, 2 nm (or 3 nm) to 35 nm. In an embodiment, the size of the semiconductor nanoparticle may be greater than or equal to about 1 nm, greater than or equal to about 2 nm, greater than or equal to about 3 nm, greater than or equal to about 4 nm, or greater than or equal to about 5 nm. In an embodiment, the size of the semiconductor nanoparticle may be less than or equal to about 50 nm, less than or equal to about 40 nm, less than or equal to about 30 nm, less than or equal to about 25 nm, less than or equal to about 20 nm, less than or equal to about 19 nm, less than or equal to about 18 nm, less than or equal to about 17 nm, less than or equal to about 16 nm, or less than or equal to about 15 nm.

The semiconductor nanoparticle may have any suitable shape. In an embodiment, the shape of the semiconductor nanoparticle may be a sphere, a polyhedron, a pyramid, a multi-pod, a cube, a nanotube, a nanowire, a nanofiber, a nanosheet, a nanoplate, or a combination thereof.

The semiconductor nanoparticle may be synthesized by any suitable method. For example, the semiconductor nanocrystal having a size of several nanometers may be synthesized through a wet chemical process. In the wet chemical process, crystal particles are grown by reacting precursor materials in an organic solvent, and growth of crystals may be controlled by coordinating the organic solvent or ligand compound on the surface of the semiconductor nanocrystals.

In an embodiment, for example, the method of preparing the semiconductor nanoparticles having a core-shell structure may include: obtaining a core; preparing a first shell precursor solution containing a first shell precursor containing a metal (e.g., zinc) and an organic ligand; preparing a second shell precursor containing a non-metal element (e.g., sulfur, selenium, or a combination thereof); and heating the first shell precursor solution to a reaction temperature (e.g., greater than or equal to about 180 °C, greater than or equal to about 200 °C, greater than or equal to about 240 °C, or greater than or equal to about 280 °C to less than or equal to about 360 °C, less than or equal to about 340 °C, or less than or equal to about 320 °C) and adding the core and the second shell precursor to form a shell of a second semiconductor nanocrystal on the first semiconductor nanocrystal core. In the semiconductor nanoparticles of embodiment, the core may be manufactured by an appropriate method known to those of ordinary skill. The method may further include preparing a core solution by separating the core from the reaction system used for a preparation thereof and dispersing the core in an organic solvent.

In an embodiment, for shell formation, a solvent and optionally a ligand compound may be heated (or vacuum-treated) under vacuum to a predetermined temperature (e.g., 100 °C or higher), and may be heated to a predetermined temperature (e.g., 100 °C or higher) after converting a reaction atmosphere for the shell formation to an inert gas atmosphere. Subsequently, the core is added thereto, and the shell precursors are sequentially or simultaneously added onto the core and then, heated at a predetermined reaction temperature to form a core-shell nanocrystal. The shell precursors may be sequentially introduced to the reaction mixture in different proportions and at different times during the reaction.

The organic solvent may include a C6 to C22 primary amine such as a hexadecylamine, a C6 to C22 secondary amine such as dioctylamine, a C6 to C40 tertiary amine such as a trioctyl amine, a nitrogen-containing heterocyclic compound such as pyridine, a C6 to C40 olefin such as octadecene, a C6 to C40 aliphatic hydrocarbon such as hexadecane, octadecane, or squalane, an aromatic hydrocarbon substituted with a C6 to C30 alkyl group such as phenyldodecane, phenyltetradecane, or phenyl hexadecane, a primary, secondary, or tertiary phosphine (e.g., trioctylphosphine) substituted with a, e.g., at least one (e.g., 1, 2, or 3), C6 to C22 alkyl group, a phosphine oxide (e.g., trioctylphosphine oxide) substituted with a (e.g., 1, 2, or 3) C6 to C22 alkyl group, a C12 to C22 aromatic ether such as phenyl ether or benzyl ether, or a combination thereof. A combination including more than one type of organic solvent may be used,

The organic ligand may coordinate the surfaces of the prepared semiconductor nanoparticles and allow the

semiconductor nanoparticles to be well dispersed in the solution. The organic ligand may include RCOOH, $RNH_2$, $R_2NH$, $R_3N$, RSH, $RH_2PO$, $R_2HPO$, RsPO, $RH_2P$, $R_2HP$, $R_3P$, ROH, RCOOR', $RPO(OH)_2$, $R_2POOH$, (wherein R and R' are each independently a substituted or unsubstituted C1 or greater, C6 or greater, or C10 or greater and C40 or less, C35 or less, or C25 or less aliphatic hydrocarbon, or a substituted or unsubstituted C6 to C40 aromatic hydrocarbon, or a combination thereof), or a combination thereof. In an embodiment, at least two different ligands may be used.

The semiconductor nanocrystals may be recovered by adding an amount of nonsolvent, for example, to remove excess organic matter, e.g., ligand, not coordinated or bound to the surface. The semiconductor nanocrystals may then be separated by centrifuging the resulting mixture. The nonsolvent may be a polar solvent that is miscible with the solvent used in the core formation reaction, shell formation reaction, or a combination thereof, and is not capable of dispersing the prepared nanocrystals. The nonsolvent may be selected depending on, e.g., taking into consideration, the solvent used in the reaction and may include, for example, acetone, ethanol, butanol, isopropanol, ethanediol, water, tetrahydrofuran (THF), dimethylsulfoxide (DMSO), diethylether, formaldehyde, acetaldehyde, ethylene glycol, a solvent having a similar solubility parameter to the foregoing solvents, or a combination thereof. The obtained semiconductor nanocrystal particles may be separated through centrifugation, sedimentation, chromatography, or distillation. The separated nanocrystals may be added to a washing solvent and then isolated, if desired. The washing solvent has no particular limit and may have a similar solubility parameter to that of the ligand and may, for example, include hexane, heptane, octane, chloroform, toluene, or benzene.

The semiconductor nanoparticles may be water-insoluble or non-dispersible in water, the aforementioned nonsolvent, or a combination thereof. The semiconductor nanoparticles may be dispersed in the aforementioned organic solvent. In an embodiment, the aforementioned semiconductor nanoparticles may be dispersed in a substituted or unsubstituted C6 to C40 aliphatic hydrocarbon, a substituted or unsubstituted C6 to C40 aromatic hydrocarbon, or a combination thereof.

The surface of the prepared semiconductor nanoparticles may be treated with a halogen compound. By halogen treatment, some organic ligands present in the semiconductor nanoparticles may be replaced with halogen. The halogen-treated semiconductor nanoparticles may contain a reduced amount of organic ligand. The halogen treatment may be performed by contacting semiconductor nanoparticles with a halogen compound (e.g., a metal halide such as zinc chloride) at a predetermined temperature, for example, about 30 °C to about 100 °C, or about 50 °C to about 150 °C in an organic solvent. The halogen-treated semiconductor nanoparticles may be separated using the aforementioned nonsolvent and separation methods.

In the display device or light emitting device, a thickness of the light emitting layer may be appropriately selected. In an embodiment, the light emitting layer may include a monolayer of semiconductor nanoparticles. In an embodiment, the light emitting layer may include one or more, for example, two or more, three or more, or four or more and 20 or less, 10 or less, 9 or less, 8 or less, 7 or less, or 6 or less monolayers of semiconductor nanoparticles. The light emitting layer may have a thickness of greater than or equal to about 5 nm, for example, greater than or equal to about 10 nm, greater than or equal to about 15 nm, greater than or equal to about 20 nm, greater than or equal to about 25 nm, or greater than or equal to about 30 nm and less than or equal to about 200 nm, for example, less than or equal to about 150 nm, less than or equal to about 100 nm, less than or equal to about 90 nm, less than or equal to about 80 nm, less than or equal to about 70 nm, less than or equal to about 60 nm, or less than or equal to about 50 nm. The light emitting layer may have a thickness of, for example about 10 nm to about 150 nm, about 20 nm to about 100 nm, or about 30 nm to about 50 nm.

The light emitting layer may have a single layer or a multilayer structure in which two or more layers are stacked. Adjacent layers in the multilayer structure (e.g., a first light emitting layer and a second light emitting layer) may be configured to emit the same color. In a multilayer structure, adjacent layers (e.g., a first light emitting layer and a second light emitting layer) may have the same or different compositions, ligands, or a combination thereof from each other. In an embodiment, the light emitting layer or the multilayer light emitting layer including two or more layers may have a halogen amount that changes in a thickness direction of the light emitting layer. In the (multilayer) light emitting layer according to an embodiment, the halogen amount may increase in a direction toward the electron auxiliary layer. In the (multilayer) light emitting layer according to an embodiment, the organic ligand amount may decrease in a direction toward the electron auxiliary layer. In the light emitting layer according to an embodiment, the halogen amount may decrease in a direction toward the electron auxiliary layer. In the (multilayer) light emitting layer according to an embodiment, the organic ligand amount may increase in a direction toward the electron auxiliary layer.

In an embodiment, the forming of the light emitting layer 3 or 30 including semiconductor nanoparticles may be carried out by obtaining a coating liquid including semiconductor nanoparticles and an organic solvent (e.g., an alkane solvent such as octane and heptane, an aromatic solvent such as toluene, or a combination thereof), and applying or depositing the coating liquid on a substrate or charge auxiliary layer (e.g., hole auxiliary layer) in an appropriate manner (e.g., by spin coating, inkjet printing, etc.). The type of the organic solvent for the semiconductor nanoparticle dispersion is not particularly limited and may be appropriately selected. In an embodiment, the organic solvent may include an (substituted or unsubstituted) aliphatic hydrocarbon organic solvent, an (substituted or unsubstituted) aromatic hydrocarbon organic solvent, an acetate solvent, or a combination thereof.

In an embodiment, the electroluminescent device may include an electron auxiliary layer disposed between the light emitting layer and the cathode. The electron auxiliary layer includes an electron transport layer. The electron transport layer includes zinc oxide nanoparticles and an organic liquid crystal compound. The electron transport layer may be present between an electrode (e.g., a second electrode or a cathode) and the light emitting layer. The electron transport layer may be disposed on (e.g., directly on) the light emitting layer. The electron transport layer may be adjacent to the light emitting layer.

In an embodiment, a layered structure may include a first electron injection conductor and a first electron transport layer disposed on a surface (e.g., a major surface) of the electron injection conductor and the first electron transport layer may include zinc oxide nanoparticles and an organic liquid crystal compound. The organic liquid crystal compound may include a cyclic group (e.g., an aromatic group); a substituted or unsubstituted C1 to C30 aliphatic hydrocarbon group; and a nitrile group or a carboxylic acid group. In an embodiment, the layered structure may further include a light emitting layer disposed on the first electron transport layer, a second electron transport layer disposed on the light emitting layer, and a second electron injection conductor disposed on the second electron transport layer.

In an embodiment, the layered structure may exhibit a current density of greater than or equal to about 100 $mA/m^2$, greater than or equal to about 105 $mA/m^2$, greater than or equal to about 110 $mA/m^2$, greater than or equal to about 115 $mA/m^2$, greater than or equal to about 120 $mA/m^2$, greater than or equal to about 125 $mA/m^2$, greater than or equal to about 130 $mA/m^2$, or greater than or equal to about 135 $mA/m^2$ at a voltage of 8 volts, when the layered structure is subjected to a sweeping test of a predetermined voltage range for a predetermined times (e.g., one, two, or three times).

In an embodiment, when the layered structure is driven at a current of about 0.2 mA for a predetermined time of, for example, less than or equal to 80 hours, less than or equal to 60 hours, less than or equal to 40 hours, less than or equal to 20 hours, less than or equal to about 60 minutes, less than or equal to about 50 minutes, less than or equal to about 40 minutes, less than or equal to about 30 minutes, or less than or equal to about 20 minutes, the layered structure may exhibit a voltage increase (i.e., a difference between the initial voltage and a voltage at a predetermined time) of less than or equal to about 1.5 volts, less than or equal to about 1.3 volts, less than or equal to about 1.2 volts, less than or equal to about 1 volt, less than or equal to about 0.9 volts, less than or equal to about 0.8 volts, less than or equal to about 0.7 volts, less than or equal to about 0.6 volts, or less than or equal to about 0.5 volt. The voltage increase may be greater than or equal to about 0.0001 volts, greater than or equal to about 0.001 volts, greater than or equal to about 0.05 volts, greater than or equal to about 0.1 volts, or greater than or equal to about 0.2 volts.

The term "zinc oxide nanoparticle" is used to define a nanoparticle that includes zinc and oxygen, and includes a nanoparticle that includes zinc, oxygen, and at least one or more of the following metals (elements). For example, a zinc oxide nanoparticle(s) may further include a Group IIA metal, zirconium (Zr), tungsten (W), lithium (Li), titanium (Ti), yttrium (Y), aluminum (Al), gallium (Ga), indium (In), tin (Sn), cobalt (Co), vanadium (V), or a combination thereof. The Group IIA metal (i.e., an alkaline-earth metal) may include magnesium, calcium, beryllium, strontium, barium, or a combination thereof.

The zinc oxide nanoparticle may have a size or an average size (hereinafter, simply referred to as "size") of greater than or equal to about 5 nm. The size of the zinc oxide nanoparticle may be less than or equal to about 50 nm. The size of the zinc oxide nanoparticles may be greater than or equal to about 1 nm, greater than or equal to about 2 nm, greater than or equal to about 2.5 nm, greater than or equal to about 3 nm, or greater than or equal to about 3.5 nm and less than or equal to about 20 nm, less than or equal to about 15 nm, less than or equal to about 10 nm, less than or equal to about 9 nm, less than or equal to about 8 nm, less than or equal to about 7 nm, less than or equal to about 6 nm, less than or equal to about 5 nm, or less than or equal to about 4.5 nm.

In an embodiment, the zinc oxide nanoparticle may include a Group IIA metal and zirconium (Zr), tungsten (W), lithium (Li), titanium (Ti), yttrium (Y), aluminum (Al), gallium (Ga), indium (In), tin (Sn), cobalt (Co), vanadium (V), or a combination thereof. The Group IIA metal may include magnesium, calcium, barium, strontium, or a combination thereof. The zinc oxide nanoparticle may include the Group IIA metal (e.g., magnesium) and optionally an additional metal. The additional metal may include zirconium (Zr), tungsten (W), lithium (Li), titanium (Ti), yttrium (Y), aluminum (Al), gallium (Ga), indium (In), tin (Sn), cobalt (Co), vanadium (V), or a combination thereof.

In an embodiment, the zinc oxide nanoparticle may include $Zn_{1-x}M^1_xO$ (where $M^1$ is a Group IIA metal and optionally, Zr, W, Li, Ti, Y, Al, gallium, indium, tin (Sn), cobalt (Co), vanadium (V), or a combination thereof, and $0 \leq x \leq 0.5$). In the chemical formula $Zn_{1-x}M'_xO$, x may be greater than or equal to about 0.01, greater than or equal to about 0.03, greater than or equal to about 0.05, greater than or equal to about 0.07, greater than or equal to about 0.1, greater than or equal to about 0.13, greater than or equal to about 0.15, greater than or equal to about 0.17, greater than or equal to about 0.2, greater than or equal to about 0.23, or greater than or equal to about 0.25. In the chemical formula $Zn_{1-x}M'_xO$, x may be less than or equal to about 0.47, less than or equal to about 0.45, less than or equal to about 0.43, less than or equal to about 0.4, less than or equal to about 0.37, less than or equal to about 0.35, or less than or equal to about 0.3.

The zinc oxide nanoparticle may further include magnesium. $M^1$ may be magnesium. The zinc oxide nanoparticle may include $Zn_{1-x}Mg_xO$ (x is greater than 0 and less than or equal to about 0.5, and x is as described herein). The x may be greater than or equal to about 0.01, greater than or equal to about 0.03, greater than or equal to about 0.05, greater than or equal to about 0.07, greater than or equal to about 0.1, greater than or equal to about 0.13, greater than or equal to about 0.15, greater than or equal to about 0.17, greater than or equal to about 0.2, greater than or equal to about 0.23, or greater than or equal to about 0.25. The x may be less than or equal to about 0.47, less than or equal to about 0.45, less than or equal to about 0.43, less than or equal to about 0.4, less than or equal to about 0.37, less than or equal to about 0.35, or less than or equal to about 0.3.

In an embodiment, the zinc oxide nanoparticle may include a zinc magnesium oxide. In an embodiment, the zinc oxide nanoparticle may further include zirconium (Zr), tungsten (W), lithium (Li), titanium (Ti), yttrium (Y), aluminum (Al), gallium (Ga), indium (In), tin (Sn), cobalt (Co), vanadium (V), or a combination thereof. The zinc oxide nanoparticle may further include an alkali metal.

The alkali metal may include cesium, potassium, rubidium, or a combination thereof.

In an embodiment, the zinc oxide nanoparticle may be prepared by an appropriate method and is not particularly limited. In an embodiment, the zinc oxide nanoparticle may be obtained as follows: a zinc compound (e.g., an organic zinc compound such as zinc acetate dihydrate) and optionally an additional metal compound (e.g., an alkali metal compound, an alkaline earth metal compound, and/or a compound of a transition metal or the additional metal described herein) are placed in a desired mole ratio in a reactor, e.g., added in a desired mole ratio to a reactor, including an organic solvent (e.g., dimethylsulfoxide) and heated to a predetermined temperature (e.g., about 40 °C to about 120 °C, or about 60 °C to about 100 °C) in air. A solution of a precipitation accelerator (e.g., an ethanol solution of tetramethylammonium hydroxide pentahydrate) may be added dropwise to the reactor at a predetermined rate and stirred. The prepared zinc oxide nanoparticle may be separated from the reaction solution by centrifugation.

The alkaline earth metal compound may include an alkaline earth metal organic compound such as a magnesium acetate hydrate, a calcium acetate hydrate, a barium acetate hydrate, or the like. The alkali metal compound may include an alkali metal carbonate compound such as cesium carbonate, lithium carbonate, rubidium carbonate, or the like.

The present inventors have found that the electron transport layer including the zinc oxide nanoparticle may contribute to providing a light emitting device having relatively improved electroluminescent properties (such as an improvement in external quantum efficiency and/or a luminance). The present inventors have also found that in case of the electron transport layer including the zinc oxide nanoparticle, there still remains a need to ameliorate a hysteresis occurring during the operation or a need to improve a life span of a device. Without wishing to be bound by any theory, in case of the electron transport layer including the zinc oxide nanoparticle, defects may be present or generated in the electron transport layer or at an interface between the electron transport layer and the light emitting layer, which may act as a trap site against a flow of a charge (e.g., hole or electron), and this can substantially affect the properties and the lifespan of the electroluminescent device.

Surprisingly, the present inventors have found that the electron transport layer including an organic liquid crystal compound and zinc oxide nanoparticles may considerably contribute to improving the light emitting properties of the electroluminescent device and extending lifetime of the device. Without wishing to be bound by any theory, it is believed that the organic liquid crystal compound included in the zinc oxide nanoparticle based electron transport layer may increase the electron mobility under an application of a voltage and may remove or passivate a trap site present in the electron transport layer. For example, the organic liquid crystal compound may passivate or fill a trap sites, whereby providing a stable charge flow without any hysteresis phenomenon and increasing life span of a device with little or no reduction in the light emitting efficiency of the device.

The organic liquid crystal compound may include a thermotropic liquid crystal compound. The thermotropic liquid crystal compound may be a compound capable of showing a liquid crystal alignment depending on a temperature change. The organic liquid crystal compound may include a thermotropic liquid crystal compound including, e.g., C3 to C60 cyclic group (e.g., an aromatic group, an alicyclic group, or a combination thereof) and optionally an aliphatic group, a polar group, or a combination thereof. As defined, the "aromatic group" or the "aromatic moiety" may include or may not include a hetero atom. As defined, the alicyclic group or the alicyclic moiety may include or may not include a heteroatom. In the organic liquid crystal compound, a cyclic structure may impart a rigidity to the liquid crystal compound. In a liquid crystal phase, the organic liquid crystal compound may have a molecular alignment form of a nematic liquid crystal, a smectic liquid crystal, or a cholesteric liquid crystal.

The organic liquid crystal compound may include a compound represented by Chemical Formula 1:

Chemical Formula 1 $R^1$-Ar- L- $R^2$

In the formula, $R^1$ is a substituted or unsubstituted C1 to C50 aliphatic hydrocarbon group, RO-, or RC(O)- (wherein, R is a substituted or unsubstituted C1 to C50 alkyl group, a substituted or unsubstituted C2 to C50 alkenyl group, a substituted or unsubstituted C2 to C50 alkynyl group),

Ar is a substituted or unsubstituted C3 to C50 aromatic moiety, a substituted or unsubstituted C3 to C50 alicyclic moiety, or any combination thereof (e.g., a moiety formed by any combination of the foregoing moieties),
L is a direct bond, a substituted or unsubstituted C1 to C20 or C2 to C10 aliphatic hydrocarbon group, C(O), O, C(O)O, NH, NHC(O), or any combination thereof (e.g., a moiety formed by any combination of the foregoing moieties),
$R^2$ is hydrogen, a cyano group, a halogen, $-CX_3$, $-CRX_2$, $-CR_2X$, wherein R is each independently hydrogen or a C1 to C10 alkyl group, X is each independently F, Cl, Br, I, or a combination thereof), or a carboxylic acid group.

In Chemical Formula 1, $R^1$ may be $C_nH_{2n+1}$, $C_nH_{2n-1}$, $C_nH_{2n+1}O$, $C_nH_{2n-1}O$, $C_nH_{2n+1}$ C(O), $C_nH_{2n-1}$ C(O), or a combination thereof, wherein n is an integer of less than or equal to about 30, for example, 1, 2, 3, 4, 5, 6, 7, 8, 9, 10, 11, 12, 13, 14, 15, 16, 17, 18, 19, 20, 21, 22, 23, 24, 25, 26, 27, 28, 29, to 30). In Chemical Formula 1, $R^1$ may be a methyl group, an ethyl group, a propyl group, an isopropyl group, a butyl group, an isobutyl group, a pentyl group, an isopentyl group, a hexyl group, an isohexyl group, a heptyl group, an isoheptyl group, an octyl group, an isooctyl group, a methyloxy group, an ethyloxy group, a propyloxy group, a butyloxy group, a pentyloxy group a hexyloxy group, a heptyloxy group, a methyl carbonyl group (or an acetyl group), an ethyl carbonyl group, a propyl carbonyl group, a butyl carbonyl group, a pentyl carbonyl group, a hexyl carbonyl group, a heptyl carbonyl group, or an octyl carbonyl group.

In Chemical Formula 1, Ar may include (or may be) a substituted or unsubstituted biphenyl moiety (e.g., a substituted or unsubstituted biphenylene group), a substituted or unsubstituted phenyl moiety (e.g., a substituted or unsubstituted phenylene group), a substituted or unsubstituted terphenyl moiety (e.g., a substituted or unsubstituted terphenylene group), a substituted or unsubstituted pyrimidine moiety, a substituted or unsubstituted pyridine moiety, a substituted or unsubstituted dioxane moiety, a substituted or unsubstituted furan moiety, a substituted or unsubstituted thiophene moiety, a substituted or unsubstituted pyridazine moiety, or any combination thereof. In an embodiment, Ar may include a moiety formed by linking at least two of the foregoing moieties.

In Chemical Formula 1, L may be a direct bond, a substituted or unsubstituted C1 to C20 alkylene group (for example, methylene, ethylene, propylene, or the like), a substituted or unsubstituted C2 to C20 alkenylene group, C(O), O, C(O)O, NH, NHC(O), or any combination thereof. In an embodiment, L of the chemical formula 1 may include a moiety formed by linking at least two selected from the foregoing moieties. For example, L may include (or may be) a moiety formed by linking the alkylene moiety and the alkenylene moiety; a moiety formed by linking the alkylene moieties via at least one of the recited moieties such as C(O), O, C(O)O, NH, or NHC(O) (e.g., an C2 to C40 alkylene group wherein at least one methylene group is replaced by any of C(O), O, C(O)O, NH, or NHC(O), or at least two of them); a moiety formed by linking the alkenylene moieties via at least one of C(O), O, C(O)O, NH, or NHC(O) (e.g., an C2 to C40 alkenylene group wherein at least one methylene group is replaced by any of C(O), O, C(O)O, NH, or NHC(O), or at least two of them).

In chemical formula 1, $R^2$ may be a cyano group (-CN) or a carboxyl group (-COOH), i.e., a carboxylic acid group.

The organic liquid crystal compound may include a biphenyl carbonitrile compound such as 4'-octyl-4-biphenylcarbonitrile, 4'-(octyloxy)-4-biphenylcarbonitrile, 4'-heptyl-4-biphenylcarbonitrile, 4'-heptyloxy-4-biphenylcarbonitrile, 4'-hexyl-4-biphenylcarbonitrile, 4'-hexyloxy-4-biphenylcarbonitrile, 4'-pentyl-4-biphenylcarbonitrile, 4'-pentyloxy-4-biphenylcarbonitrile, 4'-butyl-4-biphenylcarbonitrile, 4'-butyloxy-4-biphenylcarbonitrile, 4'-propyl-4-biphenylcarbonitrile, 4'-propyloxy-4-biphenylcarbonitrile, 4'-ethyl-4-biphenylcarbonitrile, 4'-ethyloxy-4-biphenylcarbonitrile; a phenylcyclohexane compound; a biphenyl cyclohexane compound; a fluorinated biphenyl cyclohexane compound; a fluorinated terphenyl compound; a benzoic acid compound having a C1 to C30 aliphatic hydrocarbon group or a C1 to C30 alkyl carbonyl group, for example, 4-hexylbenzoic acid, 4-butylbenzoic acid, 4-ethylbenzoic acid, an acetyl benzoic acid, or the like; or a combination thereof.

In an embodiment, the biphenyl carbonitrile compound may include a substituent group such as C1 to C30 or C2 to C18 alkyl or alkyl oxy group at a benzene ring moiety.

In an embodiment, the benzoic acid compound may include a substituent group such as C1 to C30 alkyl group or C1 to C10 alkyl carbonyl at a benzene ring moiety.

In an embodiment, the organic liquid crystal compound may include a compound represented by chemical formula 1-1 or chemical formula 1-2:

Chemical Formula 1-1

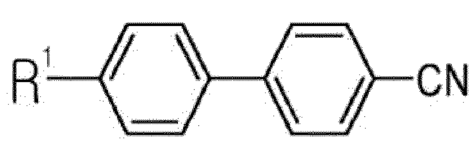

Chemical Formula 1-2

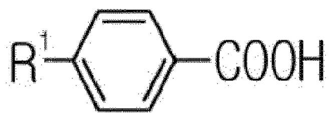

In Chemical Formula 1-1 and Chemical Formula 1-2, $R^1$ may be the same as defined in Chemical Formula 1. In an embodiment, $R^1$ may be a substituted or unsubstituted C1 to C30 or C8 to C15 alkyl group, a C1 to C18 or C8 to C10 alkoxy group, or a C1 to C10 alkylcarbonyl (RCO) group. In an embodiment, $R^1$ may be any one of the exemplified groups in Chemical Formula 1.

The biphenyl moiety of Chemical Formula 1-1, or the phenyl moiety (e.g., a benzene ring) of Chemical Formula 1-2 may be substituted or unsubstituted.

In an embodiment, the liquid crystal compound may have a molecular weight (unit: grams per mole or g/mol) of greater than or equal to about 10 g/mol, greater than or equal to about 50 g/mol, greater than or equal to about 80 g/mol, greater than or equal to about 100 g/mol, greater than or equal to about 120 g/mol, greater than or equal to about 150 g/mol, greater than or equal to about 180 g/mol, or greater than or equal to about 200 g/mol. In an embodiment, the liquid crystal compound may have a molecular weight of less than or equal to about 1500 g/mol, less than or equal to about 1000 g/mol, less than or equal to about 800 g/mol, less than or equal to about 600, less than or equal to about 500 g/mol, less than or equal to about 400 g/mol, or less than or equal to about 350 g/mol. In the embodiment, the molecular weight of the liquid crystal compound may be from about 120 g/mol to about 380 g/mol, from about 125 g/mol to about 350 g/mol, from about 130 g/mol to about 320 g/mol, or a combination thereof.

The liquid crystal compound may have a phase transition (e.g., from a crystal to smectic phase, from smectic to nematic phase, or from nematic to isotropic phase) temperature of greater than or equal to about 10 °C, greater than or equal to about 15 °C, greater than or equal to about 18 °C, greater than or equal to about 20 °C, greater than or equal to about 21 °C, greater than or equal to about 25 °C, greater than or equal to about 30 °C, greater than or equal to about 33 °C, or greater than or equal to about 40 °C. The phase transition temperature (e.g., from a crystal to smectic phase, from smectic to nematic phase, or from nematic to isotropic phase) of the organic liquid crystal compound may be from about 10 °C to about 200 °C, from about 12 °C to about 190°C, from about 18 °C to about 180 °C, from about 21 °C to about 170 °C, from about 29 to about 160 °C, from about 31 °C to about 150 °C, from about 33 °C to about 120 °C, from about 35 °C to about 100 °C, from about 40 °C to about 90 °C, from about 45 °C to about 80 °C, from about 50 °C to about 79 °C, from about 51 °C to about 77 °C, or a combination thereof.

In an embodiment, depending on the temperature, the liquid crystal compound may exhibit a smectic phase, a nematic phase, a cholesteric phase or a combination thereof.

The present inventors have found that the electron transport layer described herein may contribute to maintaining luminous properties (for example, a maximum external quantum efficiency and a maximum luminance) of the electroluminescent device at relatively high levels as well as to exhibiting the extended lifespan of the device. The present inventors have also found that a layered structure including the electron transport layer and the electrode (e.g., a cathode) or the electroluminescent device including the electron transport layer may suppress a hysteresis phenomenon that may occur otherwise.

The electron transport layer including metal oxide nanoparticles (e.g., zinc oxide nanoparticles) may be prepared in a solution process, and thereby, provide an advantage in a production process. However, the present inventors have found that as a device including the electron transport layer including nanoparticles is subjected to an experiment wherein measuring a current density with an increase in voltage applied to the device is repeated at least one time, the properties at the first sweeping may be significantly different from the properties at the second or third sweeping. Without wishing to be bound by any theory, such a hysteresis phenomenon may indicate that the given electron transport layer including nanoparticles prepared by a solution process may include a number of deep trap energy levels formed in the layer. The deep trap energy levels in the layer may act as a path for an unwanted charge movement (for example, a hole leakage).

Without wishing to be bound by any theory, it is believed that in the device of an embodiment, an electron transport layer that includes the zinc oxide nanoparticles in combination with the described organic liquid crystal compound may address the above technological problem, e.g., may in some manner passivate such deep trap defects to minimize their formation in the solution process. As a result, the charge movement (for example, an electron movement) may be facilitated and the generation of the deep trap energy levels may be suppressed or prevented.

In an embodiment, an amount of the organic liquid crystal compound in the electron transport layer may be greater than or equal to about 0.01 weight percent (wt%), greater than or equal to about 0.05 wt%, greater than or equal to about 0.1wt%, greater than or equal to about 0.3 wt%, greater than or equal to about 0.5 wt%, greater than or equal to about 1 wt%, greater than or equal to about 1.5 wt%, greater than or equal to about 2 wt%, greater than or equal to

about 2.5 wt%, greater than or equal to about 3 wt%, greater than or equal to about 3.5 wt%, greater than or equal to about 4 wt%, greater than or equal to about 4.5 wt%, or greater than or equal to about 5 wt%, based on a total weight of the zinc oxide nanoparticles and the organic liquid crystal compound.

In an embodiment, an amount of the organic liquid crystal compound in the electron transport layer may be less than or equal to about 30 wt%, less than or equal to about 20 wt%, less than or equal to about 15 wt%, less than or equal to about 13 wt%, less than or equal to about 11 wt%, less than or equal to about 10 wt%, less than or equal to about 8 wt%, less than or equal to about 7 wt%, less than or equal to about 6 wt%, or less than or equal to about 5 wt%, based on a total weight of the zinc oxide nanoparticles and the organic liquid crystal compound.

In an embodiment, an amount of the organic liquid crystal compound in the electron transport layer may be greater than or equal to about 0.3 wt% to less than or equal to about 20 wt%, greater than or equal to about 1.5 wt% to less than or equal to about 13 wt%, or greater than or equal to about 1.5 wt% to less than or equal to about 8 wt%,

The presence and the amount of the organic liquid crystal compound may be determined using any suitable analysis tool (e.g., an X-ray photoelectron spectroscopy, a (transmission or scanning) electron microscopy analysis, or the like). In an embodiment, the presence and the amount of the organic liquid crystal compound may be confirmed by separating the organic liquid crystal compound and the zinc oxide nanoparticles in a given electron transport layer via a suitable means (e.g., a dissolution) and analyze the same using a suitable analysis tool such as Fourier transform infrared spectroscopy or NMR analysis.

In an embodiment, as included in an electron only device (EOD), the electron transport layer may exhibit a relatively low level of a current (current density ($mA/cm^2$))-voltage (J-V) hysteresis in a J-V scan experiment. In such an experiment, a current density is measured as an applied voltage is varied in a predetermined range (e.g., from 0 volts to about 8 volts). Without wishing to be bound by any theory, it is believed that the J-V hysteresis may indicate or suggest the presence of defects (e.g., a trap defect) included in a given electron transport layer. The EOD including the electron transport layer of an embodiment may exhibit a J-V hysteresis of less than or equal to about 60%, less than or equal to about 55%, less than or equal to about 52%, less than or equal to about 51%, less than or equal to about 45%, less than or equal to about 40%, less than or equal to about 35%, less than or equal to about 30%, less than or equal to about 25%, less than or equal to about 23%, less than or equal to about 21%, less than or equal to about 20%, or less than or equal to about 19%, at the first sweep measurement. The J-V hysteresis may be from about 1% to about 35%, from about 3% to about 30%, from about 5% to about 28%, from about 7% to about 22%, from about 8% to about 21%, or a combination thereof.

The percent J-V hysteresis may be determined by the following equation:

$$[(A2-A1)/A2] \times 100$$

A1: a largest rectangle area in a forward scan in a given J-V graph
A2: a largest rectangle area in a backward scan in a given J-V graph.

The electron only device including the electron transport layer of an embodiment may exhibit a ratio of a hysteresis at the first sweep to a hysteresis at the second sweep that is less than or equal to about 4:1, less than or equal to about 3.5:1, less than or equal to about 3:1, less than or equal to about 2.8:1, or less than or equal to about 2.5:1. The ratio of a hysteresis at the first sweep to a hysteresis at the second sweep may be greater than or equal to about 1:1, greater than or equal to about 1.5:1, or greater than or equal to about 2:1.

A thickness of the electron transport layer may be greater than or equal to about 3 nm, greater than or equal to about 5 nm, greater than or equal to about 6 nm, greater than or equal to about 7 nm, greater than or equal to about 8 nm, greater than or equal to about 9 nm, greater than or equal to about 10 nm, greater than or equal to about 11 nm, greater than or equal to about 12 nm, greater than or equal to about 13 nm, greater than or equal to about 14 nm, greater than or equal to about 15 nm, greater than or equal to about 16 nm, greater than or equal to about 17 nm, greater than or equal to about 18 nm, greater than or equal to about 19 nm, greater than or equal to about 20 nm, greater than or equal to about 21 nm, greater than or equal to about 22 nm, greater than or equal to about 23 nm, greater than or equal to about 24 nm, greater than or equal to about 25 nm, greater than or equal to about 26 nm, greater than or equal to about 27 nm, greater than or equal to about 28 nm, greater than or equal to about 29 nm, greater than or equal to about 30 nm, greater than or equal to about 31 nm, greater than or equal to about 32 nm, greater than or equal to about 33 nm, greater than or equal to about 34 nm, or greater than or equal to about 35 nm. A thickness of the electron transport layer may be less than or equal to about 90 nm, less than or equal to about 80 nm, less than or equal to about 70 nm, less than or equal to about 60 nm, less than or equal to about 50 nm, less than or equal to about 45 nm, less than or equal to about 40 nm, or less than or equal to about 35 nm.

In an embodiment, the electron transport layer may have a first surface facing the light emitting layer and a second surface opposite the first surface. In an embodiment, in the electron transport layer, an amount of an organic

liquid crystal compound in the portion of the electron transport layer proximate to the first surface may be greater than that in a portion proximate to the second surface of the electron transport layer. In an embodiment, in the electron transport layer, an amount of an organic liquid crystal compound in the portion of the electron transport layer proximate to the first surface may be less than that in a portion proximate to the second surface of the electron transport layer.

In an embodiment, the electron transport layer may include a first layer including the first surface and a second layer including the second surface. The first layer (or the first portion), the second layer (or the second portion), or a combination thereof may include an organic liquid crystal compound, one or more alkali metal, or a combination thereof. The first layer, the second layer, or a combination thereof may include cesium, rubidium, or a combination thereof. In an embodiment, the second layer may not include an alkali metal.

In an embodiment, the amount of the organic liquid crystal compound in the first layer may be about 0.1 times or more, about 0.5 times or more, about 0.7 times or more, about 1 time or more, about 1.2 times or more, about 1.5 times or more, about 2 times or more, about 3 times or more, about 4 times or more, about 5 times or more, about 6 times or more, about 7 times or more, about 8 times or more, about 9 times or more, or about 10 times or more, of the amount of the organic liquid crystal compound in the second layer. The amount of the organic liquid crystal compound in the first layer may be about 100 times or less, about 90 times or less, about 80 times or less, about 70 times or less, about 60 times or less, about 50 times or less, about 40 times or less, about 30 times or less, about 20 times or less, about 15 times or less, 10 times or less, about 7 times or less, about 5 times or less, about 3 times or less, about 2 times or less, about 1.2 times or less, about 1 times or less, about 0.9 times or less, about 0.8 times or less, or about 0.7 times or less, of the amount of the organic liquid crystal compound in the second layer.

A thickness of the first layer may be greater than or equal to about 1 nm, greater than or equal to about 2 nm, greater than or equal to about 3 nm, greater than or equal to about 4 nm, greater than or equal to about 5 nm, greater than or equal to about 6 nm, greater than or equal to about 7 nm, greater than or equal to about 8 nm, or greater than or equal to about 9 nm. The thickness of the first layer may be less than or equal to about 15 nm, less than or equal to about 13 nm, less than or equal to about 11 nm, less than or equal to about 10 nm, less than or equal to about 9 nm, less than or equal to about 8 nm, less than or equal to about 7 nm, less than or equal to about 6 nm, less than or equal to about 5 nm, less than or equal to about 4 nm, less than or equal to about 3 nm, or less than or equal to about 2 nm.

A thickness of the second layer may be greater than or equal to about 4 nm, greater than or equal to about 5 nm, greater than or equal to about 6 nm, greater than or equal to about 7 nm, greater than or equal to about 8 nm, greater than or equal to about 9 nm, greater than or equal to about 10 nm, greater than or equal to about 11 nm, greater than or equal to about 12 nm, greater than or equal to about 13 nm, greater than or equal to about 14 nm, greater than or equal to about 15 nm, greater than or equal to about 16 nm, greater than or equal to about 17 nm, greater than or equal to about 18 nm, greater than or equal to about 19 nm, greater than or equal to about 20 nm, greater than or equal to about 25 nm, or greater than or equal to about 30 nm.

The thickness of the second layer may be less than or equal to about 50 nm, less than or equal to about 45 nm, less than or equal to about 40 nm, less than or equal to about 35 nm, less than or equal to about 30 nm, less than or equal to about 25 nm, less than or equal to about 20 nm, or less than or equal to about 15 nm.

In an embodiment, the electron auxiliary layer 4 or 40 may further include an electron injection layer, a hole blocking layer, or a combination thereof. The thickness of the electron injection layer, the hole blocking layer, or a combination thereof is not particularly limited and may be appropriately selected. A thickness of the electron injection layer, the hole blocking layer, or a combination thereof may be greater than or equal to about 5 nm, greater than or equal to about 6 nm, greater than or equal to about 7 nm, greater than or equal to about 8 nm, greater than or equal to about 9 nm, greater than or equal to about 10 nm, greater than or equal to about 11 nm, greater than or equal to about 12 nm, greater than or equal to about 13 nm, greater than or equal to about 14 nm, greater than or equal to about 15 nm, greater than or equal to about 16 nm, greater than or equal to about 17 nm, greater than or equal to about 18 nm, greater than or equal to about 19 nm, or greater than or equal to about 20 nm, and less than or equal to about 120 nm, less than or equal to about 110 nm, less than or equal to about 100 nm, less than or equal to about 90 nm, less than or equal to about 80 nm, less than or equal to about 70 nm, less than or equal to about 60 nm, less than or equal to about 50 nm, less than or equal to about 40 nm, less than or equal to about 30 nm, or less than or equal to about 25 nm, but is not limited thereto.

In an embodiment, a material for the electron injection layer, a material for the hole blocking layer, or a combination thereof may be appropriately selected and is not particularly limited.

In an embodiment, a material of the electron injection layer, hole blocking layer, or a combination thereof may include 1,4,5,8-naphthalene-tetracarboxylic dianhydride (NTCDA), bathocuproine(bathocuproine (BCP), tris[3-(3-pyridyl)-mesityl]borane (3TPYMB), LiF, Alqs, $Gaq_3$, Inqs, $Znq_2$, $Zn(BTZ)_2$, $BeBq_2$, ET204 (8-(4-(4,6-di(naphthalen-2-yl)-1,3,5-triazin-2-yl)phenyl)quinolone), 8-hydroxyquinolinato lithium (Liq), 2,2',2"-(1,3,5-Benzinetriyl)-tris(1-phenyl-1-H-benzimidazole) (TPBi), an n-type metal oxide (e.g., zinc oxide, $HfO_2$, etc.), 8-(4-(4,6-di(naphthalen-2-yl)-1,3,5-triazin-2-yl)phenyl)quinolone:8-hydroxyquinolinato lithium (ET204:Liq), or a combination thereof, but is not limited thereto.

The light emitting device according to an embodiment may further include a hole auxiliary layer. The hole

auxiliary layer is disposed between the anode and the light emitting layer. The hole auxiliary layer may include a hole injection layer, a hole transport layer, an electron (or hole) blocking layer, or a combination thereof. The hole auxiliary layer may be a layer of a single component or a multilayer structure in which adjacent layers include different components.

The hole auxiliary layer may have a HOMO energy level that can be matched with the HOMO energy level of the light emitting layer to enhance mobility of holes transferred from the hole auxiliary layer to the light emitting layer. In an embodiment, the hole auxiliary layer may include a hole injection layer proximate to the anode and a hole transport layer proximate to the light emitting layer.

The material included in the hole auxiliary layer 2 or 20 (e.g., a hole transport layer, a hole injection layer, or an electron blocking layer) is not particularly limited, and may include, for example, poly(9,9-dioctyl-fluorene-co-N-(4)-butylphenyl)-diphenylamine) (TFB), polyarylamine, poly(N-vinylcarbazole), poly(3,4-ethylenedioxythiophene) (PEDOT), poly(3,4-ethylenedioxythiophene) polystyrene sulfonate (PEDOT:PSS), polyaniline, polypyrrole, N,N,N',N'-tetrakis(4-methoxyphenyl)-benzidine (TPD), 4,4'-bis[N-(1-naphthyl)-N-phenyl-amino]biphenyl ($\alpha$-NPD), m-MTDATA (4,4',4"-Tris[phenyl(m-tolyl)amino]triphenylamine), 4,4',4"-tris(N-carbazolyl)-triphenylamine (TCTA), 1,1-bis[(di-4-toylamino)phenyl]cyclohexane (TAPC), a p-type metal oxide (e.g., NiO, WOs, $MoO_3$, etc.), a carbon-based material such as graphene oxide, or a combination thereof, but is not limited thereto.

In the hole auxiliary layer, the thickness of each layer may be appropriately selected. For example, the thickness of each layer may be greater than or equal to about 5 nm, greater than or equal to about 10 nm, greater than or equal to about 15 nm, or greater than or equal to about 20 nm and less than or equal to about 100 nm, less than or equal to about 90 nm, less than or equal to about 80 nm, less than or equal to about 70 nm, less than or equal to about 60 nm, less than or equal to about 50 nm, for example, less than or equal to about 40 nm, less than or equal to about 35 nm, or less than or equal to about 30 nm, but is not limited thereto.

A device according to an embodiment may have a normal structure. In an embodiment of FIG. 2 the device may include an anode 10 disposed on a transparent substrate 100, e.g., a metal oxide-based transparent electrode (e.g., an ITO electrode), and a cathode 50 facing the anode 10 may include a conductive metal (e.g., having a relatively low work function, Mg, Al, etc.). The hole auxiliary layer 20 (e.g., a hole injection layer such as PEDOT:PSS, a p-type metal oxide, or a combination thereof; a hole transport layer such as TFB, polyvinylcarbazole (PVK), or a combination thereof; or a combination thereof) may be provided between the transparent electrode 10 and the light emitting layer 30. The hole injection layer may be disposed close to the transparent electrode and the hole transport layer may be disposed close to the light emitting layer. The electron auxiliary layer 40 such as an electron injection/transport layer may be disposed between the light emitting layer 30 and the cathode 50.

A device according to an embodiment may have an inverted structure as depicted in FIG. 3. A second electrode 50 disposed on the transparent substrate 100 may include a metal oxide-based transparent electrode (e.g., ITO), and an anode 10 facing the cathode 50 may include a metal (e.g., having a relatively high work function, Au, Ag, etc.). For example, an (optionally doped) n-type metal oxide (crystalline Zn metal oxide) or the like may be disposed as an electron auxiliary layer 40 (e.g., an electron transport layer) between the transparent electrode 50 and the light emitting layer 30. MoOs or other p-type metal oxide may be disposed as a hole auxiliary layer 20 (e.g., a hole transport layer including TFB, PVK, or a combination thereof; a hole injection layer including MoOs or other p-type metal oxide; or a combination thereof) between the metal anode 10 and the light emitting layer 30.

In an embodiment, a method of producing an electroluminescent device includes forming the light emitting layer on the first electrode; forming an electron transport layer on the light emitting layer; and forming a second electrode on the electron transport layer.

In an embodiment, the electroluminescent device may be manufactured by optionally forming a hole auxiliary layer (e.g., by deposition or coating) on a substrate on which an electrode is formed, forming a light emitting layer including semiconductor nanoparticles (e.g., a pattern of the aforementioned semiconductor nanoparticles), and forming (optionally, an electron auxiliary layer and) an electrode (e.g., by vapor deposition or coating) on the light emitting layer. A method of forming the electrode/hole auxiliary layer/electron auxiliary layer may be appropriately selected and is not particularly limited. The formation of the light emitting layer is the same as described herein.

The forming of the electron auxiliary layer (e.g., the electron transport layer) includes forming a film including the organic liquid crystal compound and the zinc oxide nanoparticles on the light emitting layer. The forming the film may include preparing a composition (e.g. a dispersion) including the organic liquid crystal compound and the zinc oxide nanoparticles and applying the same on the light emitting layer. The composition of the dispersion may further include an organic solvent. The method may further include heat-treating the formed film.

Details of the organic liquid crystal compound and the zinc oxide nanoparticles are the same described herein. The organic liquid crystal compound may be dispersed or dissolved in an organic solvent described herein or an (organic) solvent capable of dispersing the zinc oxide nanoparticles.

The preparation of the composition may include adding the organic liquid crystal compound, the zinc oxide nanoparticles, or a combination thereof, to an organic solvent. In an embodiment, the preparation of the composition may include dissolving the organic liquid crystal compound in the organic solvent. In an embodiment, the preparation

of the composition may include dissolving or dispersing the zinc oxide nanoparticles in the organic solvent. In an embodiment, a solution including the organic liquid crystal compound and a dispersion or a solution (or dispersion) including the zinc oxide nanoparticles may be combined.

The organic solvent may be a C1 to C10 alcohol solvent or a combination thereof. The organic solvent may include a $C_{1-10}$ alcohol (e.g., ethanol, methanol, propanol, butanol, pentanol, etc.), or a combination thereof. The composition may be applied on the light emitting layer by an appropriate method (e.g., spin coating or drop casting).

The applied film may be heat-treated at a predetermined temperature, for example, greater than or equal to about 50°C, or greater than or equal to about 80°C, and less than about 250 °C, less than or equal to about 150 °C, or less than or equal to about 120 °C, in order to remove, for example, the organic solvent.

The heat treatment may be performed, for example, in an inert gas atmosphere such as nitrogen or argon or in the air. The heat-treatment temperature may be less than about 120 °C, less than or equal to about 115 °C, less than or equal to about 110 °C, less than or equal to about 105 °C, less than or equal to about 100 °C, less than or equal to about 95 °C, less than or equal to about 90 °C, or less than or equal to about 85 °C. The heat-treatment temperature may be greater than or equal to about 40 °C, greater than or equal to about 50 °C, greater than or equal to about 60 °C, greater than or equal to about 65 °C, greater than or equal to about 70 °C, or greater than or equal to about 75 °C.

In the composition, a concentration of the organic liquid crystal compound may be appropriately selected. In an embodiment, in the composition or the electron transport layer, a concentration of the organic liquid crystal compound may be greater than or equal to about 0.1 wt%, or greater than or equal to about 0.3 wt%, for example, in a range of about 0.5 to about 15 weight percentage (wt%), about 1 wt% to about 12 wt%, about 2 wt% to about 10 wt%, about 3 wt% to about 9 wt%, about 4 wt% to about 8 wt%, or a combination thereof, based on the total weight of the zinc oxide nanoparticles and the organic liquid crystal compound.

The electroluminescent device of an embodiment may exhibit an improved level of electroluminescent properties and may show an increased lifespan.

The electroluminescent device of an embodiment may exhibit a maximum external quantum efficiency (EQE) of greater than or equal to about 5%, greater than or equal to about 5.5%, greater than or equal to about 6%, greater than or equal to about 6.5%, greater than or equal to about 7%, greater than or equal to about 7.5%, greater than or equal to about 7.7%, greater than or equal to about 8%, greater than or equal to about 8.5%, greater than or equal to about 9%, greater than or equal to about 9.5%, greater than or equal to about 10%, greater than or equal to about 10.5%, greater than or equal to about 11%, greater than or equal to about 11.5%, greater than or equal to about 12%, greater than or equal to about 12.5%, greater than or equal to about 13%, greater than or equal to about 13.5%, or greater than or equal to about 14%. The electroluminescent device may exhibit the maximum external quantum efficiency (EQE) of less than or equal to about 50%, less than or equal to about 40%, less than or equal to about 30%, or less than or equal to about 20%.

The electroluminescent device may exhibit maximum luminance of greater than or equal to about 60,000 candelas per square meter ($cd/m^2$), greater than or equal to about 75,000 $cd/m^2$, greater than or equal to about 77,000 $cd/m^2$, greater than or equal to about 78,000 $cd/m^2$, greater than or equal to about 100,000 $cd/m^2$, greater than or equal to about 150,000 $cd/m^2$, greater than or equal to about 200,000 $cd/m^2$, greater than or equal to about 250,000 $cd/m^2$, or greater than or equal to about 300,000 $cd/m^2$. The electroluminescent device may exhibit a maximum luminance of less than or equal to about 5,000,000 $cd/m^2$, less than or equal to about 1,000,000 $cd/m^2$, less than or equal to about 900,000 $cd/m^2$, or less than or equal to about 500,000 $cd/m^2$.

The electroluminescent device of one embodiment may exhibit, for example, when being driven at a predetermined luminance (e.g., about 650 nit ($cd/m^2$)), a T50 of greater than or equal to about 20 hours, for example, greater than or equal to about 25 hours, greater than or equal to about 30 hours, greater than or equal to about 40 hours, greater than or equal to about 50 hours, greater than or equal to about 60 hours, greater than or equal to about 65 hours, greater than or equal to about 70 hours, greater than or equal to about 80 hours, greater than or equal to about 90 hours, greater than or equal to about 100 hours, greater than or equal to about 110 hours, greater than or equal to about 115 hours, greater than or equal to about 120 hours, greater than or equal to about 125 hours, greater than or equal to about 130 hours, greater than or equal to about 140 hours, or greater than or equal to about 145 hours. The T50 may range from about 25 hours to about 1,000 hours, about 26 hours to about 500 hours, about 26.5 hours to about 300 hours, or a combination thereof.

The electroluminescent device may exhibit, for example, when being driven at a predetermined luminance (e.g., about 650 nit), a T90 of greater than or equal to about 15 hours, greater than or equal to about 16 hours, greater than or equal to about 17 hours, greater than or equal to about 20 hours, greater than or equal to about 23 hours, greater than or equal to about 25 hours, or greater than or equal to about 30 hours. The electroluminescent device may exhibit a T90 of about 7 hours to about 1,000 hours, about 8 hours to about 800 hours, about 10 hours to about 500 hours, about 50 hours to about 300 hours, about 80 hours to about 250 hours, about 90 hours to about 120 hours, or a combination thereof (when driven at a predetermined luminance, for example, 650 nit).

An embodiment relates to a display device including the aforementioned electroluminescent device.

The display device may include a first pixel and a second pixel configured to emit light of a color differing from that of the first pixel. In the first pixel, the second pixel, or a combination thereof, the electroluminescent device according to an embodiment (e.g., with the electron transport layer described herein) may be disposed. In an embodiment, the display device may further include a blue pixel, a red pixel, a green pixel, or a combination thereof. In the display device, the red pixel may include a red light emitting layer including a plurality of red light emitting semiconductor nanoparticles, the green pixel may include a green light emitting layer including a plurality of green light emitting semiconductor nanoparticles, and the blue pixel may include a blue light emitting layer including a plurality of blue light emitting semiconductor nanoparticles.

The display device may include a portable terminal device, a monitor, a laptop, a television, an electric sign board, a camera, or an electronic component.

Hereinafter, specific examples are illustrated. However, these examples are exemplary, and the present disclosure is not limited thereto.

## Examples

### Analysis Methods

#### 1. Electroluminescence Spectroscopic Analysis

A current is measured with a Keithley 2635B source meter as a voltage is applied. A CS2000 spectrometer is used to measure electroluminescence (EL) light-emitting luminance.

#### 2. Life-span characteristic

(1) T50: represents a time in hours (hr) for luminance to reach 50% of initial luminance when driven with a predetermined luminance of 650 nit (candelas per square meter),
T90: represents a time in hours (hr) for luminance to reach 90% of initial luminance when driven with a predetermined luminance of 650 nit (candelas per square meter).

#### 3. Photoluminescence Analysis

Photoluminescence (PL) analysis is performed by using a Hitachi F-7000 spectrophotometer.

#### 4. JV hysteresis

The percent J-V hysteresis is determined by the following equation:

$$[(A2-A1)/A2] \times 100$$

A1: a largest rectangle area in a forward scan in a given J-V graph
A2: a largest rectangle area in a backward scan in a given J-V graph.

The following synthesis is performed under an inert gas atmosphere (under a nitrogen), unless otherwise specified. A precursor amount is a molar amount, unless otherwise specified.

### Synthesis Example 1:

Selenium (Se), sulfur (S) and tellurium (Te) are dispersed in trioctylphosphine (TOP) to prepare a Se/TOP stock solution, a S/TOP stock solution, and a Te/TOP stock solution, respectively. To a reactor containing trioctylamine, 0.125 millimoles (mmol) of zinc acetate with oleic acid are added, and then the mixture is heated to 120 °C under vacuum. After 1 hour, an atmosphere of nitrogen is introduced into the reactor. The reactor is heated to 300°C, and the prepared Se/TOP stock solution and Te/TOP stock solution in a Te:Se ratio of 1:20 are rapidly injected into the heated reactor. Upon completion of the reaction, the reaction mixture is rapidly cooled to room temperature, and then acetone is added to facilitate formation of a precipitate. The precipitate is separated by centrifugation and dispersed in toluene to obtain ZnSeTe core particles in toluene.

To a reaction flask containing trioctylamine, 1.8 mmol of zinc acetate and oleic acid are added, and the mixture is vacuum-treated, e.g., subjected to vacuum conditions at 120 °C for 10 minutes. An atmosphere of nitrogen is introduced into the flask and the flask heated to 180 °C. The above prepared ZnTeSe core particles are added to the flask followed by the injection of the prepared Se/TOP and S/TOP stock solutions. The reaction temperature is set at about 280 °C. Upon completion of the reaction, the reactor is cooled, ethanol is added, and the nanocrystals are separated with a centrifuge and dispersed in toluene, to prepare blue light-emitting semiconductor nanoparticles.

By a photoluminescence analysis, it is confirmed that the blue light-emitting semiconductor nanoparticles have a maximum luminescent peak wavelength of 455 nanometers (nm).

The blue light-emitting synthesized semiconductor nanoparticles (optical density: 0.25 at 420 nm, 6 milliliters (mL)) are precipitated in ethanol again and then, centrifuged and re-dispersed in cyclohexane, to prepare a cyclohexane dispersion. An amount of 0.022 millimoles (mmol) of zinc chloride dissolved in ethanol is added to the cyclohexane dispersion and stirred at 80 °C for 30 minutes. The treated semiconductor nanoparticles are again separated through centrifugation and dispersed in octane, to prepare an octane dispersion.

Synthesis Example 2: Synthesis of ZnMgO Nanoparticles

Zinc acetate dihydrate and magnesium acetate tetrahydrate are added to a reactor containing dimethyl sulfoxide and heated to 60 °C under air. An ethanol solution of tetramethylammonium hydroxide pentahydrate is then added to the reactor. After 1 hour of stirring a precipitate forms that is then separated with a centrifuge and dispersed in ethanol, obtaining $Zn_{1-x}Mg_xO$ nanoparticles. (x = 0.15)

A transmission electron microscope analysis of the nanoparticles confirms that the particles have an average size of about 3 nm.

Examples 1 to 3:

An electroluminescent device with a structure of indium tin oxide (ITO)/poly(3,4-ethylenedioxythiophene) polystyrene sulfonate (PEDOT:PSS) (30 nm)/poly(9,9-dioctyl-fluorene-co-N-(4)-butylphenyl)-diphenylamine) (TFB) (25 nm)/quantum dot (QD) light emitting layer (32 nm)/electron transport layer (ETL) (20 nm)/Al (100 nm) is manufactured according to the following method:
An organic liquid crystal compound solution is prepared by dissolving 4'-propyl-4-biphenylcarbonitrile (hereinafter, "3CB", Cas No. 58743-76-3, Tokyo Chemical Industry) in ethanol. The zinc magnesium oxide nanoparticles according to Synthesis Example 2 are dispersed in ethanol to prepare a dispersion, which is mixed with the organic liquid crystal compound solution, preparing an ETL dispersion. In the ETL dispersion, an amount of the organic liquid crystal compound is 2 weight percent (wt%) for Example 1, 4 wt% for Example 2, and 6 wt% for Example 3, based on a total weight of the zinc oxide nanoparticles and the organic liquid crystal compound.

After surface-treating a glass substrate deposited with ITO with ultraviolet (UV)-ozone for 15 minutes, a PEDOT:PSS solution (H.C. Starks, Inc.) is spin-coated thereon and heat-treated at 150 °C for 10 minutes under an air atmosphere and then, at 150 °C for 20 to 30 minutes under a $N_2$ atmosphere to form a 30 nm-thick hole injection layer. On the hole injection layer (HIL), a poly[(9,9-dioctylfluoren-2,7-diyl-co-(4,4'-(N-4-butylphenyl)diphenylamine] solution (TFB) (Sumitomo Corp.) is spin-coated and heat-treated at 180 °C for 30 minutes, forming a 25 nm-thick hole transport layer (HTL). On the hole transport layer (HTL), the octane dispersion of Synthesis Example 1 is spin-coated to form a 32 nm-thick light emitting layer.

On the light emitting layer, each of the above dispersions for ETL including zinc oxide nanoparticles and the organic liquid crystal compound of Examples 1 to 3 is spin-coated and heat-treated at 80 °C, forming an electron transport layer (thickness: 20 nm). On the prepared electron transport layer, aluminum (Al) is vacuum-deposited, e.g., deposited under vacuum, to be 100 nm thick, e.g., deposited to a thickness of 100 nm, forming a cathode and manufacturing a light emitting device.

The electroluminescent properties and the lifespan of the electroluminescent device are measured, and the results are shown in Table 1.

Example 4:

An electroluminescent device is prepared in the same manner as in Example 1 except that instead of 3CB, 4-hexylbenzoic acid (6BA, Cas No: 21643-38-9, Tokyo Chemical Industry) is used in an amount of about 4 wt% based on a total weight of the zinc oxide nanoparticles and the organic liquid crystal compound.

The electroluminescent properties and the lifespan of the electroluminescent devices are measured and the results are shown in Table 1.

Comparative Example 1:

A device is manufactured in the same manner as in Example 1 except that an electron transport layer (ETL) is formed of a dispersion prepared by dispersing the zinc magnesium oxide nanoparticles of Synthesis Example 2 in ethanol without using the 3CB.
The electroluminescent properties and the lifespan of the electroluminescent device are measured, and the results are shown in Table 1.

Table 1

| | Maximum EQE (%) | Maximum luminance (nit) | T90 (hours) | T50 (hours) |
|---|---|---|---|---|
| Example 1 (3CB 2%) | 12 % | about 75000 | 28 | beyond 170 |
| Example 2 (3CB 4%) | 10% | about 79000 | 40 | beyond 170 |
| Example 3 (3CB 6%) | 13% | about 78000 | 20 | beyond 170 |
| Example 4 (6BA 4%) | 13% | about 77000 | 39 | beyond 170 |
| Comparative Example 1 (Ref ZMO) | 10% | about 75000 | below 11 | around 110 |

The results of Table 1 confirm that the electroluminescent device of Examples 1 to 4 exhibits a combination of EQE and luminance together with substantially longer lifetimes compared with the device of Comparative Example 1 (ETL with no organic liquid crystal compound).

Example 5:

An electroluminescent device is prepared in the same manner as in Example 1 except that instead of 3CB, 4-butylbenzoic acid (hereinafter, 4BA, Cas No. 20651-71-2, Tokyo Chemical Industry) is used in an amount of about 4 wt% based on a total weight of the zinc oxide nanoparticles and the organic liquid crystal compound.
Electroluminescent properties of the electroluminescent device are measured, and the results confirm that the EL properties and the lifespan are similar to those of the device of Example 1.

Experimental Example 1: EOD evaluation I

An organic liquid crystal compound solution is prepared by dissolving 4'-butyl-4-biphenylcarbonitrile ("4CB," Cas No. 52709-83-8, Tokyo Chemical Industry) in ethanol. The zinc magnesium oxide nanoparticles according to Synthesis Example 2 are dispersed in ethanol and mixed with the organic liquid crystal compound solution to prepare an ETL dispersion. In an ETL dispersion, an amount of the organic liquid crystal compound is 4 weight percent (wt%) based on a total weight of the zinc oxide nanoparticles and the organic liquid crystal compound.

After surface-treating a glass substrate deposited with ITO with ultraviolet (UV)-ozone for 15 minutes, the zinc magnesium oxide nanoparticles prepared in Synthesis Example 2 are dispersed in ethanol to prepare a dispersion, which is used to form a ZnMgO electron transport layer having a thickness of about 20 nm. On the formed ZnMgO electron transport layer, the octane dispersion of the semiconductor nanoparticles prepared in Synthesis Example 1 is spin-coated to form a light emitting layer with a thickness of about 20 nm. On the light emitting layer, the ETL dispersion (4 wt% 4CB, Example 6) is coated and thermally-treated at about 80 °C to form an electron transport layer having a thickness of about 20 nm, respectively, and then, an Al electrode is deposited thereon to obtain a device of Example 6.
The zinc magnesium oxide nanoparticles according to Synthesis Example 2 are dispersed in ethanol to obtain an ETL dispersion without an organic liquid crystal compound. A device of Comparative Example 2 is prepared in the same manner set forth for the device of Example 6, except for using the ETL dispersion without an organic liquid crystal compound.
A voltage (0 to 8 volts (V), i.e., a bias voltage) is applied between the ITO electrode and the Al electrode, in a forward scan or in a backward scan and a current density is measured. The results are shown in Table 1.

Table 2

| | hysteresis (1st sweep) | hysteresis (2nd sweep) | 8V current density (3rd sweep) |
|---|---|---|---|
| Example 6 | 20% | 8% | about 140 $mA/m^2$ |
| Comparative Example 2 | 31% | 6% | about 50 $mA/m^2$ |

FIG. 4 (Comparative Example 2) and FIG. 5 (Example 6), and the results of Table 2 confirm that the EOD of Example 6 exhibits significantly reduced hysteresis at the first sweep in comparison with the EOD of Comparative Example 2. Without wishing to be bound by any theory, the occurrence of the hysteresis at the first sweep may be related with filling of the charges in the defect traps. FIG. 4 and FIG. 5, and the results of Table 2 confirm that the EOD of Example 6 exhibits a significantly high level of current density at 8 volts, which indicates that the incorporation of the liquid crystal compound may improve the electron transport in addition to reducing the defect traps.

Experimental Example 2: EOD evaluation II

An organic liquid crystal compound solution is prepared by dissolving the 3CB in the ethanol. The zinc magnesium oxide nanoparticles according to Synthesis Example 2 are dispersed in ethanol to prepare a dispersion, which is then mixed with the organic liquid crystal compound solution to provide an ETL dispersion. In the ETL dispersion, an amount of the organic liquid crystal compound is varied to be 0 wt%, 3 wt%, 4 wt%, and 6 wt%, based on a total weight of the zinc oxide nanoparticles and the organic liquid crystal compound, respectively.

The EOD is prepared in the same manner as set forth in Example 6.

The EOD is driven at a static current of about 0.2 milliamperes (mA) to measure a change in a voltage. The results are shown in FIG. 6 and Table 3.

Table 3

| | Initial Voltage (volts) | A voltage at 60 hours (volts) |
|---|---|---|
| ZMO | About 1.7 | About 3.72 |
| ZMO:PCB6 % | About 1.9 | About 2.5 |
| ZMO:PCB4 % | About 1.3 | About 1.83 |
| ZMO:PCB3 % | About 1.36 | About 1.95 |

The results of FIG. 6 and FIG. 3 confirm that in case of the EOD having the electron transport layer including the organic liquid crystal compound, the voltage increase (i.e., a voltage difference between an initial voltage and a voltage at a predetermined time, e.g., 60 hours) is less than or equal to about 1.5 volts, or less than about 1 volt, In contrast, an EOD having the electron transport layer that does not include the organic liquid crystal compound, the voltage increase is over 2 volts.

While this disclosure has been described in connection with what is presently considered to be practical example embodiments, it is to be understood that the invention is not limited to the disclosed embodiments. On the contrary, it is intended to cover various modifications and equivalent arrangements included within the scope of the appended claims.

## Claims

**1.** An electroluminescent device, comprising:

an anode;
a cathode;
a light emitting layer comprising a plurality of semiconductor nanoparticles, the light emitting layer being disposed between the anode and the cathode; and
an electron transport layer disposed between the light emitting layer and the cathode, wherein the electron transport layer comprises zinc oxide nanoparticles and an organic liquid crystal compound.

**2.** The electroluminescent device of claim 1, wherein
the electroluminescent device is configured to emit blue light, green light, or red light, and the plurality of semiconductor nanoparticles do not comprise cadmium, lead, mercury, or a combination thereof.

**3.** The electroluminescent device of claims 1 or 2, wherein the zinc oxide nanoparticles further comprise a Group IIA metal, Zr, W, Li, Ti, Y, Al, gallium, indium, tin, cobalt, vanadium, or a combination thereof.

**4.** The electroluminescent device of any of claims 1-3, wherein

the zinc oxide nanoparticles further comprise an alkali metal;
preferably wherein
the alkali metal comprises potassium, rubidium, cesium, or a combination thereof.

**5.** The electroluminescent device of any of claims 1-4, wherein

the organic liquid crystal compound comprises a thermotropic liquid crystal compound having a cyclic moiety; and/or
wherein
in the electron transport layer, an amount of the organic liquid crystal compound is greater than or equal to 0.01 weight percent and less than or equal to 30 weight percent, based on a total weight of the zinc oxide nanoparticle and the organic liquid crystal compound.

**6.** The electroluminescent device of any of claims 1-5, wherein

the organic liquid crystal compound comprises a compound represented by Chemical Formula 1:

Chemical Formula 1 $R^1$ -Ar- L- $R^2$

wherein

$R^1$ is a substituted or unsubstituted C1 to C50 aliphatic hydrocarbon group, RO-, or RC(O)- wherein, R is a substituted or unsubstituted C1 to C50 alkyl group, a substituted or unsubstituted C2 to C50 alkenyl group, or a substituted or unsubstituted C2 to C50 alkynyl group,
Ar is a substituted or unsubstituted C3 to C50 aromatic moiety, a substituted or unsubstituted C3 to C50 alicyclic moiety, or any combination thereof,
L is a direct bond, a substituted or unsubstituted C1 to C20 aliphatic hydrocarbon group, C(O), O, C(O)O, NH, NHC(O), or any combination thereof,
$R^2$ is hydrogen, a cyano group, a halogen, $-CX_3$, $-CRX_2$, $-CR_2X$ wherein R is each independently hydrogen or a C1 to C10 alkyl group, and X is each independently F, Cl, Br, I, or a combination thereof, or a carboxylic acid group.
preferably wherein in Chemical Formula 1,
$R^1$ is $C_nH_{2n+1}$, $C_nH_{2n-1}$, $C_nH_{2n+1}O$, $C_nH_{2n-1}O$, $C_nH_{2n+1}C(O)$, $C_nH_{2n-1}C(O)$, or a combination thereof, wherein n is an integer from 1 to 30,
Ar is a substituted or unsubstituted biphenyl moiety, a substituted or unsubstituted phenyl moiety, a substituted or unsubstituted terphenyl moiety, a substituted or unsubstituted pyrimidine moiety, a substituted or unsubstituted pyridine moiety, a substituted or unsubstituted dioxane moiety, a substituted or unsubstituted furan moiety, a substituted or unsubstituted thiophen moiety, a substituted or unsubstituted pyridazine moiety, or any combination thereof,
L is a direct bond, a substituted or unsubstituted C1 to C10 alkylene group, a substituted or unsubstituted C2 to C10 alkenylene group, C(O), O, C(O)O, NH, NHC(O), or any combination thereof, and
$R_2$ is a cyano group or a carboxylic acid group.

**7.** The electroluminescent device of any of claims 1-6, wherein the organic liquid crystal compound comprises a biphenyl carbonitrile compound, a phenyl cyclohexane compound, a biphenyl cyclohexane compound, a fluorinated cyclohexane biphenyl compound, a fluorinated terphenyl compound, a benzoic acid compound having a substituted or unsubstituted C1 to C30 aliphatic hydrocarbon group, an acetyl benzoic acid compound, or a combination thereof

**8.** The electroluminescent device of any of claims 1-7, wherein the organic liquid crystal compound has a molecular weight of greater than or equal to 50 g/mol and less than or equal to 1500 g/mol, and/or

the organic liquid crystal compound has a phase transition temperature from 18 °C to 120 °C.

**9.** The electroluminescent device of any of claims 1-8, wherein

the electron transport layer has a first surface facing the light emitting layer and a second surface opposite the first surface, and
an amount of the organic liquid crystal compound in a portion of the electron transport layer proximate to the first surface is greater than an amount of the organic liquid crystal compound in a portion proximate to the second surface of the electron transport layer.

**10.** The electroluminescent device of any of claims 1-9,
wherein the electroluminescent device is configured to exhibit a maximum external quantum efficiency of greater than or equal to 10% and a T90 of greater than or equal to 15 hours when operated at 650 nit.

**11.** A display device comprising the electroluminescent device of any of claims 1-10;

preferably wherein
the display device comprises a portable terminal device, a monitor, a notebook computer, a television, an electric sign board, a camera, or an electronic component.

**12.** A layered structure comprising

a first electron injecting conductor; and
a first electron transporting layer disposed on a major surface of the first electron injecting conductor,
wherein the first electron transporting layer comprises zinc oxide nanoparticles and an organic liquid crystal compound,
wherein the zinc oxide nanoparticles have a size of greater than or equal to 0.5 nanometers and less than or equal to 50 nanometers, and
wherein the organic liquid crystal compound includes a cyclic group; a substituted or unsubstituted C1 to C30 aliphatic hydrocarbon group; and a nitrile group or a carboxylic acid group.

**13.** The layered structure of claim 12, wherein in the first electron transporting layer, an amount of the organic liquid crystal compound is greater than or equal to 0.01 weight percent and less than or equal to 30 weight percent based on a total weight of the zinc oxide nanoparticle and the organic liquid crystal compound; and/or
wherein the organic liquid crystal compound comprises a biphenyl carbonitrile compound, a phenyl cyclohexane compound, a biphenyl cyclohexane compound, a fluorinated cyclohexane biphenyl compound, a fluorinated terphenyl compound, a benzoic acid compound having a substituted or unsubstituted C1 to C30 aliphatic hydrocarbon group, an acetyl benzoic acid compound, or a combination thereof.

**14.** The layered structure of claims 12 or 13, wherein the layered structure further comprises a light emitting layer disposed on the first electron transport layer, a second electron transport layer disposed on the light emitting layer, and a second electron injecting conductor disposed on the second electron transport layer.

**15.** The layered structure of any of claims 12-14, wherein the layered structure is configured to exhibit a current density of greater than or equal to 100 milliamperes per square meter at a voltage of 8 volts, or
wherein the layered structure is configured to exhibit a voltage increase of less than or equal to 1.5 volts, when a current of 0.2 milliamperes is applied to the structure.

FIG. 1

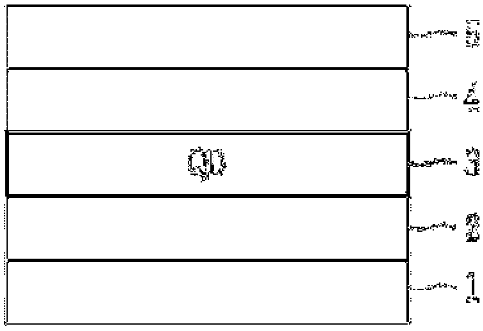


FIG. 2

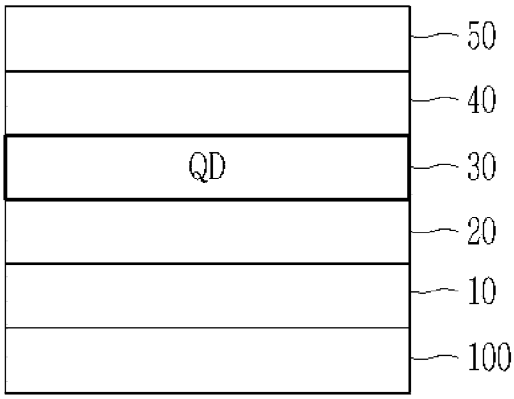


FIG. 3

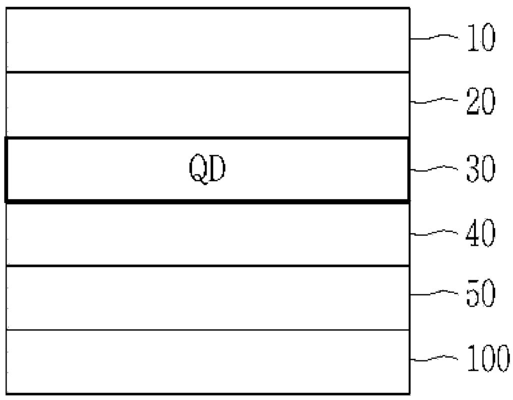

FIG. 4

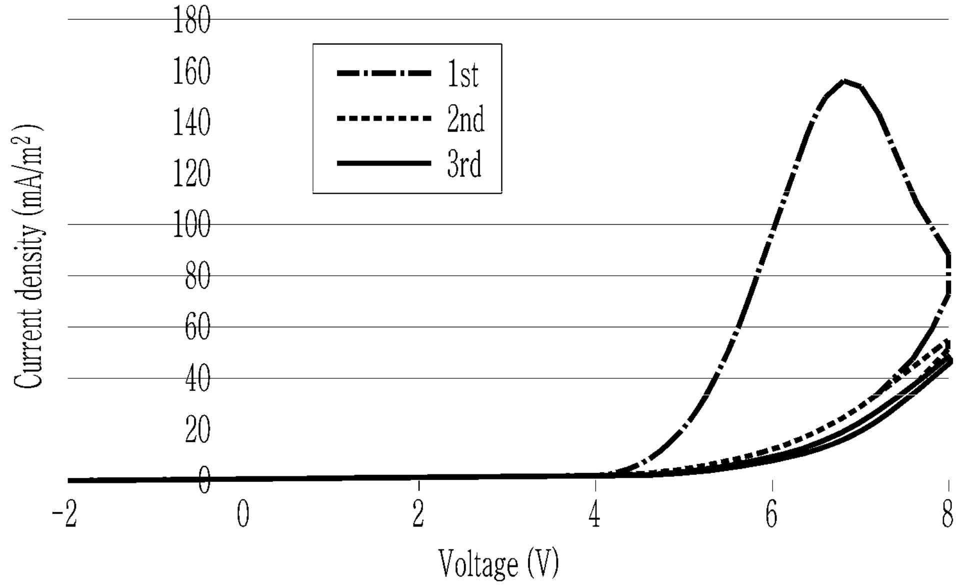
1st
2nd
3rd
Current density (mA/m²)
180
160
140
120
100
80
60
40
20
0
-2
0
2
4
6
8
Voltage (V)

FIG. 5

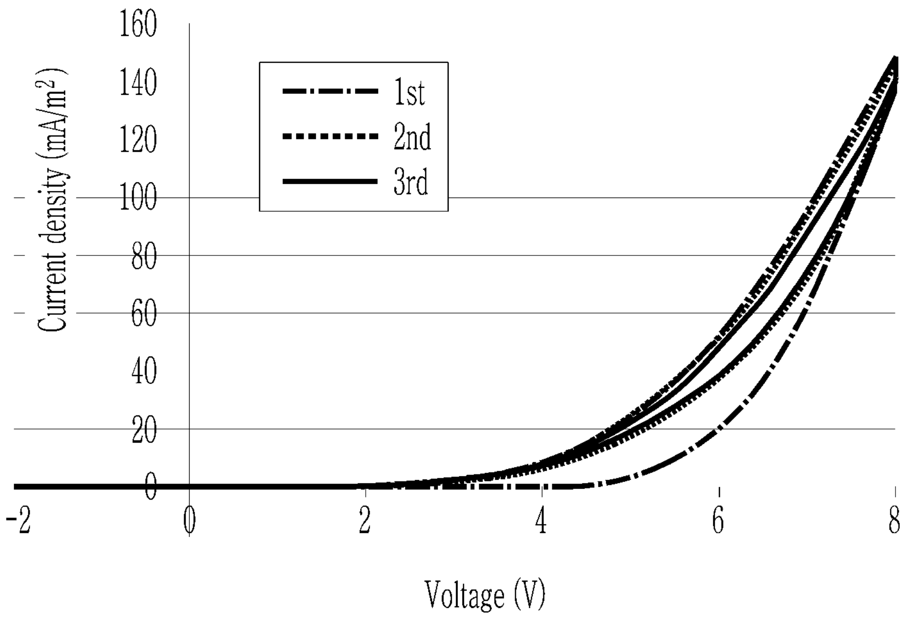
1st
2nd
3rd
Current density (mA/m²)
160
140
120
100
80
60
40
20
0
-2
0
2
4
6
8
Voltage (V)

FIG. 6

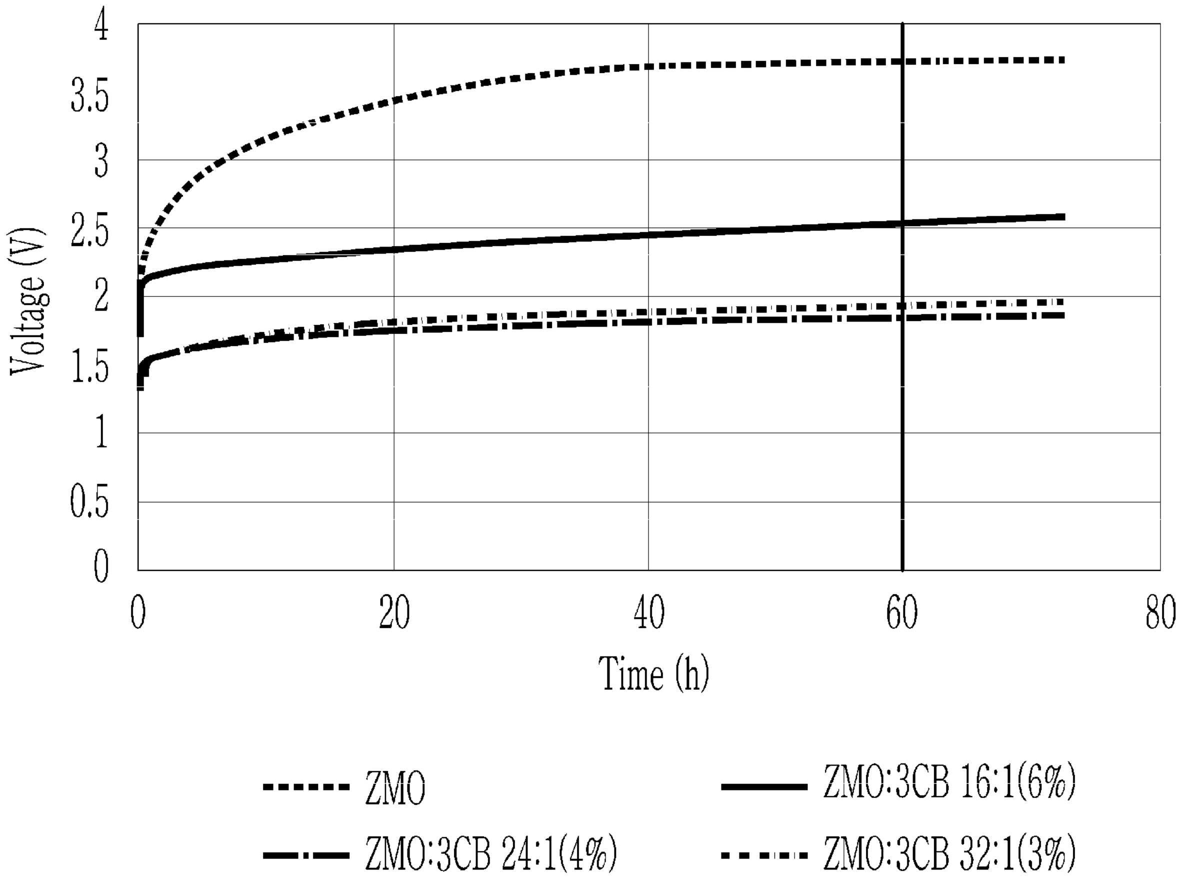
4
3.5
3
2.5
2
1.5
1
0.5
0
Voltage (V)
0
20
40
60
80
Time (h)
ZMO
ZMO:3CB 16:1(6%)
ZMO:3CB 24:1(4%)
ZMO:3CB 32:1(3%)

Europäisches Patentamt
European Patent Office
Office européen des brevets

# EUROPEAN SEARCH REPORT

Application Number
EP 22 21 6871

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 3 597 724 A1 (SAMSUNG ELECTRONICS CO LTD [KR]) 22 January 2020 (2020-01-22) * paragraph [0074] - paragraph [0185]; figures 1-8; examples 1-15; tables 1,2 * ----- | 1-15 | INV. H10K50/16 H10K50/165 |
| A | KR 2021 0143567 A (LG CHEMICAL COMPANY LTD) 29 November 2021 (2021-11-29) * paragraph [0001] - paragraph [0074]; claims 1-8; figure 1; table 1 * ----- | 1-15 | |
| A | WO 2017/156433 A1 (RED BANK TECH LLC [US]) 14 September 2017 (2017-09-14) * the whole document * ----- | 1-15 | |

TECHNICAL FIELDS SEARCHED (IPC)

H10K

The present search report has been drawn up for all claims

1

| Place of search | Date of completion of the search | Examiner |
|---|---|---|
| The Hague | 12 May 2023 | Konrádsson, Ásgeir |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO.

EP 22 21 6871

This annex lists the patent family members relating to the patent documents cited in the above-mentioned European search report. The members are as contained in the European Patent Office EDP file on
The European Patent Office is in no way liable for these particulars which are merely given for the purpose of information.

12-05-2023

| Patent document cited in search report | | Publication date | Patent family member(s) | | | Publication date |
|---|---|---|---|---|---|---|
| EP 3597724 | A1 | 22-01-2020 | CN | 110729404 | A | 24-01-2020 |
| | | | EP | 3597724 | A1 | 22-01-2020 |
| | | | KR | 20200008976 | A | 29-01-2020 |
| | | | US | 2020028105 | A1 | 23-01-2020 |
| KR 20210143567 | A | 29-11-2021 | NONE | | | |
| WO 2017156433 | A1 | 14-09-2017 | CN | 108779396 | A | 09-11-2018 |
| | | | CN | 115572603 | A | 06-01-2023 |
| | | | EP | 3426751 | A1 | 16-01-2019 |
| | | | JP | 7181796 | B2 | 01-12-2022 |
| | | | JP | 2019512883 | A | 16-05-2019 |
| | | | KR | 20180119668 | A | 02-11-2018 |
| | | | KR | 20220032643 | A | 15-03-2022 |
| | | | US | 2019157572 | A1 | 23-05-2019 |
| | | | US | 2021013429 | A1 | 14-01-2021 |
| | | | US | 2022271239 | A1 | 25-08-2022 |
| | | | WO | 2017156433 | A1 | 14-09-2017 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description


- *CHEMICAL ABSTRACTS,* 58743-76-3
- *CHEMICAL ABSTRACTS,* 21643-38-9
- *CHEMICAL ABSTRACTS,* 20651-71-2
- *CHEMICAL ABSTRACTS,* 52709-83-8